(19) Europäisches Patentamt
European Patent Office
Office européen des brevets

(11) **EP 2 128 876 B1**

(12) **EUROPEAN PATENT SPECIFICATION**

(45) Date of publication and mention
of the grant of the patent:
**22.05.2013  Bulletin 2013/21**

(51) Int Cl.:
*C23C 14/08* (2006.01)     *C23C 14/02* (2006.01)
*C23C 14/58* (2006.01)     *H01B 1/08* (2006.01)
*C03C 17/245* (2006.01)

(21) Application number: **08721503.4**

(22) Date of filing: **06.03.2008**

(86) International application number:
**PCT/JP2008/054083**

(87) International publication number:
**WO 2008/114620 (25.09.2008 Gazette 2008/39)**

(54) **PROCESS FOR PRODUCING ELECTROCONDUCTOR**

PROZESS ZUM HERSTELLEN EINES ELEKTROLEITERS

PROCEDE DE FABRICATION D'UN CONDUCTEUR ELECTRIQUE

(84) Designated Contracting States:
**AT BE BG CH CY CZ DE DK EE ES FI FR GB GR
HR HU IE IS IT LI LT LU LV MC MT NL NO PL PT
RO SE SI SK TR**

(30) Priority: **19.03.2007   JP 2007070990
29.08.2007   JP 2007222989**

(43) Date of publication of application:
**02.12.2009   Bulletin 2009/49**

(73) Proprietor: **Asahi Glass Company, Limited
Chiyoda-ku
Tokyo 100-8405 (JP)**

(72) Inventors:
• **YAMADA, Naoomi
Kawasaki-shi
Kanagawa 213-0012 (JP)**
• **HITOSUGI, Taro
Kawasaki-shi
Kanagawa 213-0012 (JP)**

• **HASEGAWA, Tetsuya
Kawasaki-shi
Kanagawa 213-0012 (JP)**

(74) Representative: **Müller-Boré & Partner
Patentanwälte
Grafinger Straße 2
81671 München (DE)**

(56) References cited:
WO-A1-2006/016608     JP-A- 02 191 330
JP-A- 2003 281 947     JP-A- 2005 141 981
JP-A- 2006 144 052     US-A1- 2003 064 179

• HITOSUGI T; UEDA A; FURUBAYASHI Y; HIROSE
Y; KONUMA S; SHIMADA T; HASEGAWA T:
"Fabrication of TiO2-based transparent
conducting oxide films on glass by pulsed laser
deposition" JAPANESE JOURNAL OF APPLIED
PHYSICS, PART 2: LETTERS 20070112 JAPAN
SOCIETY OF APPLIED PHYSICS; KUDAN-KITA
BUILDING 5TH FLOOR JP, vol. 46, no. 3, 12
January 2007 (2007-01-12), pages L86-L88,
XP002563900 DOI: 10.1143/jjap.46.l86

EP 2 128 876 B1

**Description**

The present invention relates to a process for producing a titanium oxide type electrical conductor having good transparency.

In recent years, there has been an increasing demand for large sizing of liquid crystal display panels and for small size portability. To satisfy such a demand, low consumption of electric power by a display element is required, and it becomes essential to apply a transparent electrode having a high visible light transmittance and a low electrical resistance.

Particularly, an organic electroluminescence device which has been recently being developed, is self-light emitting type, and it is effective in application to a small size portable terminal, but has a problem that it is a current drive type and its power consumption is large. Whereas, a plasma display panel (PDP) which is currently being spread in the market, and a field emission display (FED) which is being developed as a next-generation display, have a problem that they have a high power consumption structure. Under these circumstances, it is highly desired to lower the electrical resistance of a transparent electrically conductive thin film.

A typical example of a transparent electrically conductive thin film is an indium-tin oxide film (hereinafter referred to as an ITO film) made of a tin-doped indium oxide. Such an ITO film is excellent in transparency and has high electrical conductivity, but it has a drawback that the crustal content of In is as small as 50 ppb, and the raw material cost will increase along with depletion of the resource.

In recent years, attention has been drawn to titanium oxide ($TiO_2$) having both chemical resistance and durability, as a material for a transparent electrical conductor (e.g. the following Non-Patent Document 1).

The following Patent Document 1 proposes a method to obtain a transparent electrical conductor by forming a metal oxide layer made of $M:TiO_2$ (where M is Nb, Ta, etc.) having an anatase type crystal structure, on a substrate. Here, it is disclosed that a single crystal thin film (solid solution) of $M:TiO_2$ having an anatase type crystal structure, formed by epitaxial growth, will remarkably improve the electrical conductivity while maintaining the transparency.

The following Patent Document 2 proposes a method to obtain a transparent electrically conductive thin film laminate by forming a laminate having a hydrogen-containing transparent high refractive index thin film layer and a metal thin layer alternately laminated on a transparent substrate. The transparent high refractive index thin film layer is, for example, made of titanium oxide.

Non-Patent Document 1:    Applied Physics, vol. 73, No. 5 (2004) p.587-592
Patent Document 1:        WO2006/016608
Patent Document 2:        JP-A-2004-95240

The single crystal thin film of $M:TiO_2$ having an anatase type crystal structure as disclosed in Patent Document 1, is difficult to produce and thus has a low possibility of practical application. In the case of the transparent high refractive index thin film layer disclosed in Patent Document 2, hydrogen is incorporated during the layer forming, whereby the transparency tends to be inadequate. Thus, it was not easy to realize an electrical conductor having a low electrical resistance and being excellent in transparency.

Further, none of the above-mentioned references discloses annealing after forming a metal oxide.

WO 2006/016608 discloses that an anatase $Nb:TiO_2$ polycrystal layer is formed on glass. Japanese Journal of Applied Physics, Vol. 46, No. 3, 2007, pp. L86-L88, discloses that Nb-doped anatase $TiO_2$ is formed on a substrate and heating is carried out.

The present invention has been made under these circumstances, and it is an object of the present invention to provide a process whereby a titanium oxide electrical conductor excellent in electrical conductivity and having a good transparency can be produced with good productivity.

The present invention is a process for producing an electrical conductor, which comprises a laminate-forming step of forming a precursor laminate having a first precursor layer and a second precursor layer laminated in an optional order on a substrate, and an annealing step of heating the precursor laminate in a reducing atmosphere for annealing to form a metal oxide layer from the first precursor layer and the second precursor layer, wherein: the first precursor layer is a titanium oxide layer made of titanium oxide containing at least one dopant selected from the group consisting of Nb, Ta, Mo, As, Sb, Al, Hf, Si, Ge, Zr, W, Co, Fe, Cr, Sn, Ni, V, Mn, Tc, Re, P and Bi, and the titanium oxide layer is a titanium oxide layer which, when subjected to a single layer annealing test, becomes a titanium oxide layer containing a polycrystal which is free from a rutile type crystal, and the second precursor layer is an amorphous titanium oxide layer made of titanium oxide containing at least one dopant selected from the above group, and the amorphous titanium oxide layer is an amorphous titanium oxide layer which, when subjected to a single layer annealing test, becomes a titanium oxide layer containing a polycrystal which contains a rutile type crystal. Preferably, the first precursor layer has an absorption coefficient of larger than $0 \, cm^{-1}$ and less than $2 \times 10^4 \, cm^{-1}$ at a wavelength of 800 nm, and the second precursor layer has an absorption coefficient of at least $2 \times 10^4 \, cm^{-1}$ and less than $5 \times 10^4 \, cm^{-1}$ at a wavelength of 800 nm.

According to the present invention, a precursor laminate comprising a plurality of layers is formed, and specific annealing is carried out, whereby it is possible to produce an electrical conductor made of a layer composed of titanium oxide as the main component, which is excellent in electrical conductivity and has good transparency, with good productivity.

Fig. 1 is a cross-sectional view showing a state wherein a metal oxide layer is laminated on a substrate.

Fig. 2 is a view illustrating a case wherein a precursor laminate is formed by a sputtering method.

Fig. 3 is graphs showing the results of measurement of the resistivity, carrier concentration and Hall mobility in a case where single layer annealing is carried out by changing the $O_2$ flow ratio during the layer forming.

Fig. 4 is a graph showing the results of measurement by X-ray diffraction (XRD profile) in a case where single layer annealing is carried out by changing the $O_2$ flow ratio during the layer forming.

Fig. 5 is graphs showing the results of measurement of the transmittance, reflectance and absorptance, before annealing, of a film formed at an $O_2$ flow ratio of 0 vol%.

Fig. 6 is graphs showing the results of measurement of the transmittance, reflectance and absorptance, before annealing, of a film formed at an $O_2$ flow ratio of 1.0 vol%.

Fig. 7 is graphs showing the results of measurement of the resistivity, carrier concentration and hall mobility of a metal oxide layer of the present invention.

Fig. 8 is a graph showing the results of measurement by X-ray diffraction (XRD profile) of a metal oxide layer of the present invention.

Fig. 9 is a graph showing the results of measurement by X-ray diffraction (XRD profile) of a metal oxide layer of the present invention.

Fig. 10 is graphs showing the results of measurement of the transmittance, reflectance and absorptance of a metal oxide layer of the present invention. Fig. 10(a) shows the results of measurement before annealing, and Fig. 10(b) shows the results of measurement after annealing.

Fig. 11 is graphs showing the temperature dependency of the resistivity, carrier concentration and hall mobility, in a metal oxide layer of the present invention.

Fig. 12 is graphs showing results of measurement of the transmittance, reflectance and absorptance of a metal oxide layer of the present invention.

Fig. 13 is graphs showing the dependency on the thickness of the first precursor layer, of the resistance, carrier concentration and hall mobility, in a metal oxide layer of the present invention.

Fig. 14 is graphs showing the $O_2$ flow ratio dependency of the resistivity, carrier concentration and hall mobility, in a metal oxide layer of the present invention.

Fig. 15 is graphs showing the results of measurement of the transmittance, reflectance and absorptance, in a film annealed after formed at an $O_2$ flow ratio of 1.0 vol%.

MEANINGS OF SYMBOLS

10:    Substrate
11:    First precursor layer
12:    Second precursor layer
13:    Precursor laminate
13':    Metal oxide layer

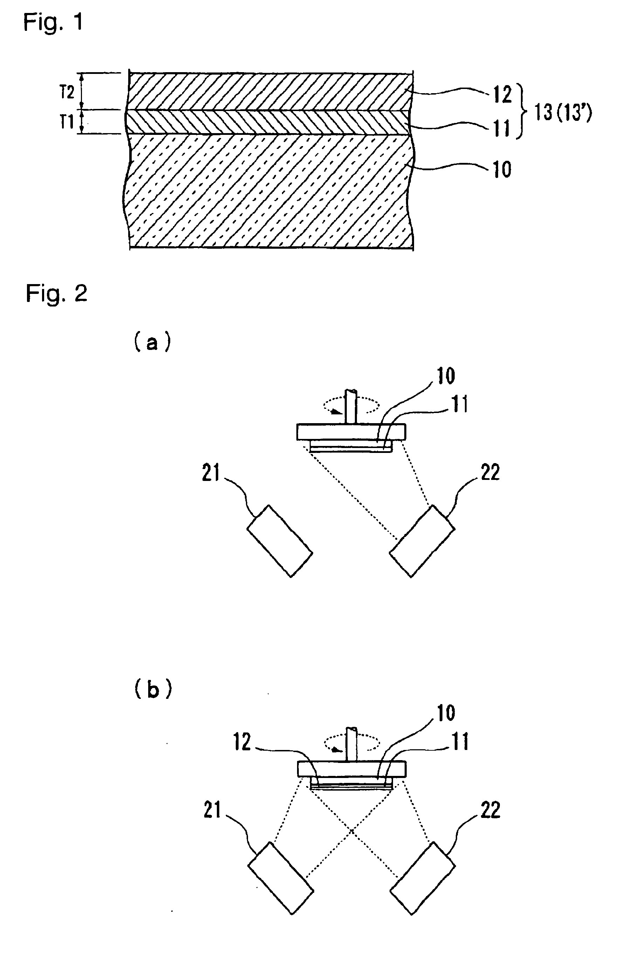

Fig. 1 is a cross-sectional view of an electrical conductor according to this embodiment. In this embodiment, firstly, on the surface of a substrate 10 (base material), a first precursor layer 11 made of titanium oxide which contains a dopant, is formed, and thereon, a second precursor layer 12 made of titanium oxide which contains a dopant, is formed. A laminate of the first precursor layer 11 and the second precursor layer 12 is referred to as a precursor laminate 13.

And, the precursor laminate 13 is annealed in a reducing atmosphere to obtain a metal oxide layer 13'. The metal oxide layer 13' thus obtained is excellent in transparency and electrical conductivity and thus is suitable as an electrical conductor.

<SUBSTRATE>

The material of the substrate (base plate 10) is not particularly limited. It may, for example, be single crystal material, polycrystal material or amorphous material, or a material having such crystal states mixed.

As a specific example, it may, for example, be a substrate made of a single crystal or polycrystal of strontium

titanate ($SrTiO_3$); a single crystal substrate or polycrystal substrate made of rock salt type crystal having a perovskite type crystal structure or its analogous structure; a substrate made of a single crystal or polycrystal of gallium nitride; a single crystal substrate or polycrystal substrate of a nitride or oxide of zinc blende crystal having a wurtzite-type crystal structure or its analogues structure; a quartz substrate; a glass substrate made of a glass material such as non-alkali glass (such as product name; AN100, manufactured by Asahi Glass Company, Limited) or soda lime glass; a plastic substrate made of a plastic material such as polyimide, polyethylene terephthalate, polyethylene naphthalate, triacetyl acetonate, polyethersulfone, polycarbonate, polyethylene, polyvinyl chloride, polypropylene or polymethacrylate; or a semiconductor substrate such as a silicon substrate having a thermal oxidation film formed on its surface (thermally oxidized Si substrate). The substrate may contain a dopant, impurities, etc. within a range not to impair the effects of the present invention.

In a case where a single crystal substrate of $SiTiO_3$ is used as the substrate, it is preferably a substrate having the substrate surface finished to be a (100) face. Because, on such a single crystal substrate surface, an anatase type crystal structure will be readily formed by epitaxial growth.

On the other hand, in the case of a glass substrate, the surface is amorphous, whereby a rutile type structure was likely to be formed by a conventional method. However, in the present invention, an anatase type crystal structure will be formed, whereby it is possible to obtain a good electrically conductive film as compared with the conventional method. That is, according to the process of the present invention, even with a substrate of which at least a part of the surface is amorphous, it is possible to form a good electrically conductive film on the surface of such a substrate.

In the present invention, the crystal state of the substrate is preferably a polycrystal state, an amorphous state or a state wherein polycrystal and amorphous are mixed.

In the present invention, the shape of the substrate is not particularly limited. It may, for example, be a plate form substrate 10, or a film form such as a plastic film.

The thickness of the substrate 10 is not particularly limited. In a case where transparency is required for the substrate 10, it is preferably at most 1 mm. In a case where a plate form substrate 10 is required to have a mechanical strength, and the transmittance may be sacrificed to some extent, it may be thicker than 1 mm. For example, the thickness of the substrate 10 is preferably from 0.2 to 1 mm.

As the substrate 10, one polished as the case requires, may be used. A substrate having crystallinity such as an $SrTiO_3$ substrate is preferably used by polishing it. For example, it may be mechanically polished by using a diamond slurry as a polishing material. In such mechanical polishing, it is preferred that the particle size of the diamond slurry to be used is gradually refined, and finally, mirror polishing is carried out by a diamond slurry having a particle size of about 0.5 $\mu$m. Thereafter, by further polishing the substrate by using a colloidal silica, planarization may be carried out until the root-mean-square roughness (RMS) of the surface roughness becomes at most 10 Å (1 nm).

Prior to forming the first precursor layer 11, the substrate 10 may be pretreated. Such pretreatment may be carried out, for example, by the following procedure. Firstly, the substrate is cleaned with e.g. acetone or ethanol. Then, the substrate is immersed in highly pure hydrochloric acid (e.g. EL grade, concentrate: 36 mass%, manufactured by Kanto Chemical Co., Ltd.) for 2 minutes. Then, the substrate is transferred into pure water to rinse hydrochloric acid, etc. Then, the substrate is transferred into fresh pure water, and ultrasonic wave cleaning is carried out therein for 5 minutes. Then, the substrate is take out from pure water, and nitrogen gas is blown to the surface of the substrate to remove moisture from the surface of the substrate. Such treatment is carried out, for example; at room temperature. It is considered that by such treatment, oxides, organic substances, etc. are removed from the surface of the substrate. In the above, hydrochloric acid is mentioned as an example, but instead, an acid such as aqua regia or hydrofluoric acid may be used. Further, the treatment by an acid may be carried out at room temperature or a heated acid may be used.

<DOPANT>

Each of the first precursor layer 11 and the second precursor layer 12 is made of titanium oxide containing at least one dopant selected from the group consisting of Nb, Ta, Mo, As, Sb, Al, Hf, Si, Ge, Zr, W, Co, Fe, Cr, Sn, Ni, V, Mn, Tc, Re, P and Bi. The titanium oxide in the present invention is one having Ti sites of $TiO_2$ substituted by metal atoms M (dopant atoms), and it may sometimes be represented by "$M:TiO_2$". In this specification, "titanium oxide" and "$TiO_2$" include "$TiO_{2-\delta}$ (where $\delta$ is an oxygen deficiency amount)" unless otherwise specified.

In the first precursor layer 11 and the second precursor layer 12, the content of impurities other than the dopant metal atoms (M), oxygen atoms (O) and titanium atoms (Ti) is preferably at most 0.1 atomic%, more preferably at most 0.01 atomic%.

Particularly when Nb, Ta, Mo, As, Sb, Al, Hf, Si, Ge, Zr or W is used as the dopant, it can be expected to improve the electrical conductivity while maintaining the transparency of the metal oxide layer 13'. Further, when Co, Fe, Cr, Sn, Ni, V, Mn, Tc, Re, P or Bi is used as the dopant, a magneto-optical effect or ferromagnetism can be expected.

Among the above-mentioned dopants, it is preferred to employ Nb, Ta, Mo, As, Sb or W, and it is particularly preferred to employ Nb and/or Ta, whereby the electrical conductivity will be good.

The dopant to be added to the first precursor layer 11 and the dopant to be added to the second precursor layer 12 may be the same or different.

The content of the dopant atoms to titanium atoms (Ti) in each of the first precursor layer 11 and the second precursor layer 12 is maintained after the annealing. Accordingly, the content of the dopant atoms in the first precursor layer 11 and the second precursor layer 12 is set depending upon the content of the dopant atoms of the metal oxide layer 13' to be obtained after the annealing.

The content of the dopant atoms in the first precursor layer 11 and the content of the dopant atoms in the second precursor layer 12 may be the same or different.

The content of dopant atoms in each of the first precursor layer 11 and the second precursor layer 12 is preferably more than 0 atomic% and at most 50 atomic%, based on the total amount of titanium atoms (Ti) and metal atoms (M) of the dopant being 100 atomic% (the same applies hereinafter). If it is larger than 50 atomic%, the characteristics of $TiO_2$ as the matrix material in the metal oxide layer 13' after the annealing tend to be weak. It is more preferably at most 20 atomic%, particularly preferably at most 10 atomic%.

On the other hand, in order to satisfy both the high transparency and the low electrical resistance in the metal oxide layer 13' after the annealing, each of the content of dopant atoms in the first precursor layer 11 and the content of dopant atoms in the second precursor layer 12 is more preferably at least 1 atomic%.

Further, it is also possible to adjust the light transmission property in the metal oxide layer 13' by the content of dopant atoms. For example, by increasing the doped amount of Nb atoms, it is possible to cut off a red color region of long wavelengths thereby to let only blue color be transmitted.

<LAMINATE-FORMING STEP>

Firstly, on the substrate 10, the precursor laminate 13 having the first precursor layer 11 and the second precursor layer 12 laminated, is formed. In the present invention, the lamination order of the first precursor layer 11 and the second precursor layer 12 is not limited. In this embodiment, firstly, the first precursor layer 11 is formed on the substrate 10, and the second precursor layer 12 is formed thereon.

The first precursor layer 11 and the second precursor layer 12 may be formed by optionally employing a known film-forming method. Specifically, a physical vapor deposition (PVD) method such as a pulsed laser deposition (PLD) method or a sputtering method; a chemical vapor deposition (CVD) method such as a MOCVD method; or a film forming method by a synthesis process from a solution, such as a sol-gel method or a chemical solution method, may, for example, be mentioned.

The PLD method is particularly preferred, since a good film state can easily be obtained, and a sputtering method is preferred in that film forming is easy irrespective of the crystallinity of the substrate.

In a case where a sputtering method is to be used, a method is preferred in which a first precursor layer 11 is formed on the substrate 10 by a reactive sputtering method in an atmosphere gas containing an oxidative sputtering gas, and then, on the first precursor layer 11, the second precursor layer 12 is formed by a reactive sputtering method in an atmosphere gas containing an oxidizing sputtering gas. As the sputtering apparatus, a known apparatus may suitably be used. For example, a reactive DC magnetron sputtering apparatus may be used.

Specifically, firstly, in a vacuum chamber of the sputtering apparatus, a target and a substrate 10 are set. On the rear side of the target, a magnet is disposed. Then, the interior of the vacuum chamber is evacuated by a pump to a vacuum state, and then, a sputtering gas is introduced to adjust the pressure to a prescribed sputtering pressure. Then, while maintaining the sputtering pressure, a magnetic field of a prescribed intensity is formed by the magnet on the rear side of the target, and at the same time a prescribed voltage is applied to the target to form the first precursor layer 11 on the substrate.

The sputtering pressure during film formation is, for example, preferably at a level of from 0.1 to 5.0 Pa, more preferably at a level of from 0.3 to 3.0 Pa.

[TARGET]

The target to be used for film formation may be a metal target or a metal oxide target, or both may be used in combination. As the metal target, for example, a titanium alloy containing a prescribed amount of a dopant may, for example, be used. As the metal oxide target, a $TiO_2$ sintered body containing a prescribed amount of a dopant may, for example, be used. For example, a Nb:$TiO_2$ sintered body may be prepared by mixing powders of $TiO_2$ and $Nb_2O_5$ weighed so that they become a desired metal atom ratio and hot forming the mixed powders. A plurality of dopants may be contained in one target.

The content of dopant atoms to titanium atoms (Ti) in a target will be substantially equal to the content of dopant atoms in a film formed by using such a target. Accordingly, it is preferred to set the content of dopant atoms in the target depending upon the content of dopant atoms in the first precursor layer 11 or the second precursor layer 12 to be obtained.

The content of dopant atoms in a target is preferably more than 0 atomic% and at most 50 atomic%, based on the total amount of titanium atoms (Ti) and metal atoms (M) of the dopant being 100 atomic%. If it becomes larger than 50 atomic%, the characteristics of $TiO_2$ as the matrix material in the metal oxide layer 13' after annealing tend to be weak. The content of such dopant atoms is preferably at most 20 atomic%, more preferably at most 10 atomic%. On the other hand, the content of dopant atoms in the target is more preferably at least 1 atomic% in order to satisfy high transparency and low electrical resistance in the metal oxide layer 13' after annealing.

In a composition of a metal oxide target, the ratio of the number of O atoms to the number of Ti atoms (O/Ti ratio) is preferably within a range of from 0.5 to 2.0. That is, $M:TiO_{2-\delta}:0 \leqq \delta \leqq 1.5$ is preferred. If the O/Ti ratio is smaller than this range, the film tends to be colored, and it becomes difficult to satisfy the transparency and electrical conductivity at the same time. An oxide having an O/Ti ratio larger than this range is difficult to produce. When the O/Ti ratio is within a range of from 1.0 to 2.0, the transparency and the electrical conductivity of the film are likely to be satisfied at the same time. Further, when the O/Ti ratio is within a range of from 1.5 to 2.0, it is possible to obtain a film having a higher transparency.

The crystal structure of the metal oxide target may be any one of rutile type, anatase type, brookite type and magneli phase, or a mixture thereof.

[SPUTTERING GAS]

As the sputtering gas, at least an oxidizing sputtering gas is employed, and preferably, a gas mixture comprising an oxidizing sputtering gas and an inert gas is employed.

As the inert gas, at least one member selected from Ar, He, Ne, Kr and Xe may be used. As the oxidizing sputtering gas, at least one member selected from $O_2$, $O_3$, $H_2O$ and $CO_2$ may be used. From the viewpoint of safety and maintenance of the film formation device, it is preferred to employ $O_2$ as the oxidizing sputtering gas.

The concentration of the oxidizing sputtering gas in the atmosphere gas for film formation can be adjusted by the proportion of the flow rate of the oxidizing sputtering gas based on the total flow rate of the sputtering gas introduced to the vacuum chamber (hereinafter sometimes referred to as a flow ratio of the oxidizing sputtering gas). For example, in a case where a gas mixture of an oxidizing sputtering gas and an inert gas is employed as the sputtering gas, the above-mentioned total flow rate of the sputtering gas is the total of the flow rate of the oxidizing sputtering gas and the flow rate of the inert gas.

[SUBSTRATE TEMPERATURE: FIRST PRECURSOR LAYER]

The first precursor layer 11 is formed so that it will be an amorphous layer, or a layer containing a polycrystal which is free from a rutile type crystal. For this purpose, the substrate temperature at the time of forming the first precursor layer 11 is preferably at most 600°C. If it exceeds 600°C, a rutile type crystal is likely to be formed. The lower limit value of the substrate temperature during such film formation is not particularly limited so long as it is a temperature at which the film can be formed. It is for example 77 K (about a -196°C).

In order to bring the resistance of the metal oxide layer 13' to be lower, the first precursor layer 11 is preferably an amorphous layer, and for this purpose, the substrate temperature during the film formation is preferably at most room temperature. In this specification, "room temperature" for the substrate temperature during the film formation, is a temperate range, which the substrate temperature can take when the film formation is carried out without heating the substrate, and it is at a level of from 25 to 80°C in a sputtering method. Accordingly, in order to make the first precursor layer 11 to be amorphous, it is preferred to carry out the film formation in a state where the substrate is not heated. It is more preferred to maintain the substrate temperature during the film formation to at a level of e.g. from 25 to 50°C, and it is preferred to cool it, as the case requires.

Further, in a case where the first precursor layer 11 is a layer containing a polycrystal, after annealing, such a polycrystal may not contain a rutile type crystal. Accordingly, an amorphous layer may be formed, for example, at a substrate temperature of not higher than room temperature, and such an amorphous layer may be annealed at a temperature of at least the crystallization temperature so that no rutile type crystal will be formed, thereby to form a layer containing a polycrystal, which may be used as the first precursor layer 11.

[SUBSTRATE TEMPERATURE: SECOND PRECURSOR LAYER]

The second precursor layer 12 is formed so that it will be an amorphous layer. For this purpose, the substrate temperature at the time of forming the second precursor layer 12 is preferably at most room temperature. That is, it is preferred to form the second precursor layer 12 in a state where the substrate is not heated. It is more preferred to maintain the substrate temperature during the film formation at a level of e.g. from 25 to 50°C, and it is preferred to cool it as the case requires. The lower limit of the substrate temperature during the film formation is not particularly limited so long as it is a temperature at which a film can be formed. It is for example 77 K (about -196°C).

The crystal state of the first precursor layer 11 and the second precursor layer 12 can be ascertained by an XRD profile. That is, by an X-ray diffraction (XRD) apparatus, an XRD profile is measured to observe the presence or absence of (101) and (004) peaks observed as a characteristic of an anatase type polycrystal and a (110) peak observed as a characteristic of a rutile type polycrystal. In a case where neither peak is observed, such a layer is judged to an amorphous layer, and in a case where either peak is observed, such a layer is judged to be a layer containing a polycrystal. Further, when a (110) peak is observed, such a polycrystal is judged to contain a rutile type crystal, and when no (110) peak is observed, such a polycrystal is judged to contain no rutile type crystal.

[CONDITIONS (1) AND (2) TO BE SATISFIED BY FIRST PRECURSOR LAYER 11 AND SECOND PRECURSOR LAYER 12]

Condition (1): When subjected to a single layer annealing test by the following method, the first precursor layer 11 will be formed so that it becomes a layer containing a polycrystal which is free from a rutile type crystal, and the second precursor layer 12 will be formed so that it becomes a layer containing a polycrystal which contains a rutile type crystal.

Condition (2): The first precursor layer 11 is formed so that it has an absorption coefficient of larger than 0 cm$^{-1}$ and less than $2 \times 10^4$ cm$^{-1}$, preferably more than 0 cm$^{-1}$ and less than $1 \times 10^4$ cm$^{-1}$, at a wavelength of 800 nm, and the second precursor layer 12 is formed so that it has an absorption coefficient of at least $2 \times 10^4$ cm$^{-1}$ and less than $5 \times 10^4$ cm$^{-1}$, preferably at least $3 \times 10^4$ cm$^{-1}$ and at most $4 \times 10^4$ cm$^{-1}$, at a wavelength of 800 nm.

The first precursor layer 11 and the second precursor layer 12 satisfy above condition (1) or may satisfy both conditions at the same time.

By forming the first precursor layer 11 and the second precursor layer 12 so that they satisfy the above condition (1) or both conditions (1) and (2), it is possible to obtain a metal oxide layer 13' which has a low electrical resistance and is excellent in transparency.

(SINGLE LAYER ANNEALING TEST)

In the present invention, the single layer annealing test on the first precursor layer 11 is carried out by the following procedure by using a sample film formed in a thickness of 100 nm on a non-alkali glass substrate.

Firstly, on the surface of a substrate made of non-alkali glass (product name: AN 100, manufactured by Asahi Glass Company, Limited), a sample film is formed by using a target having the same composition and the same film forming conditions as for forming the first precursor layer 11 in an actual laminate-forming step. However, the thickness of the sample film is 100 nm irrespective of the thickness of the actual first precursor layer 11.

Then, the sample film is subjected to a single layer annealing test. That is, the annealing atmosphere is once evacuated to a vacuum of 10$^{-1}$ Pa, and then hydrogen (H$_2$) is introduced to make an atmosphere of 100% H$_2$. The atmosphere pressure at that time is $1.013 \times 10^5$ Pa (1 atm). Then, in the H$_2$ atmosphere, a heating element is brought in contact with the rear surface of the substrate to heat the substrate so that the substrate temperature reaches 500°C from room temperature (about 25°C) in 5 minutes. And, the temperature was maintained at 500°C for 1 hour and then left to cool to room temperature.

With respect to the sample film after thus subjected to a single layer annealing test, the XRD profile is measured by an X-ray diffraction (XRD) apparatus, and the crystal state is judged in the same manner as in the above-described method for judging the crystal state in the first precursor layer 11.

Here, in a case where the first precursor layer 11 is one subjected to annealing after forming an amorphous layer, the sample film to be subjected to the single layer annealing test, is formed by carrying out annealing after forming an amorphous layer in the same manner.

The single layer annealing test on the second precursor layer 12 is carried out in the same manner as the single layer annealing test on the first precursor layer 11 except that in the above-mentioned single layer annealing test on the first precursor layer 11, the conditions for forming the sample film are changed to use a target having the same composition and the same film forming conditions as for forming the second precursor layer 12 in an actual laminate-forming step. Also judgment of the crystal state in the sample film after subjected to the single layer annealing test, is the same as the above-mentioned method for judging the crystal state in the first precursor layer 11.

(ABSORPTION COEFFICIENT)

In the present invention, the value of "an absorption coefficient at a wavelength of 800 nm" is obtained by the following method.

Firstly, the transmittance and the reflectance at a wavelength of 800 nm are measured. When the measured value of the transmittance is T (%), the measured value of the reflectance is R (%), and the film thickness is d (cm), the absorption coefficient $\alpha$ (cm$^{-1}$) is calculated by the following formula (I).

$$\alpha=\{1n(100/T)+1n(1-R/100)\}/d \qquad (I)$$

With respect to the above condition (1), in the single layer annealing test, the substrate temperature at the time of annealing is 500°C, whereby even if a sample film before annealing is amorphous or contains a polycrystal, the sample film after the annealing contains a polycrystal. When the film forming conditions are adjusted to such conditions that the oxygen content in the film will be small, a rutile type crystal tends to be contained in the film after the single layer annealing test.

Further, in a case where in the single layer annealing test, the sample film before annealing contains a polycrystal which is free from a rutile type crystal, the polycrystal in the sample film after the annealing is free from a rutile type crystal.

With respect to the above condition (2), if the film forming conditions are adjusted to be such conditions that the oxygen content in the film will be small, the absorption coefficient at a wavelength of 800 nm tends to be large.

In a case where the first precursor layer is an amorphous layer formed to satisfy the above condition (2), when the amorphous layer is heated to a temperature of at least the crystallization temperature, an anatase type crystal is likely to be formed, and a rutile type crystal tends to be hardly formed.

In a case where the first precursor layer is a layer containing a polycrystal, formed by satisfying the above condition (2), such a polycrystal contains no rutile type crystal. Accordingly, also after the annealing, it contains no rutile type crystal.

In a case where the second precursor layer is an amorphous layer formed to satisfy the above condition (2), when such an amorphous layer is heated to a temperature of at least the crystallization temperature in a single layer state, a rutile type crystal will be formed.

In this embodiment, the method for controlling the oxygen content in the film in order to satisfy the above condition (1) and or both conditions (1) and (2), may, for example, be (A) a method of controlling the concentration of the oxidizing sputtering gas in the atmosphere gas during the film formation, or (B) a method of controlling the content of oxygen atoms in the target to be used for the film formation.

In order to control the oxygen content in the film, such methods may be used alone, or the methods (A) and (B) may be used in combination.

[(A) FLOW RATIO OF OXIDIZING SPUTTERING GAS]

In the case of the above method (A), the concentration of the oxidizing sputtering gas in the atmosphere gas can be controlled specifically by the flow ratio of the oxidizing sputtering gas during the film formation. In a case where the content of oxygen atoms in the target is constant, the oxygen content in the film becomes small, as the flow ratio of the oxidizing sputtering gas becomes small.

Specifically, for example, in a case where the target is made of a metal oxide (M:TiO$_{2-\delta 1}$:$0\leqq\delta 1\leqq 1.5$) in order to satisfy the above condition (1) or both conditions (1) and (2), the flow ratio of the oxidizing sputtering gas at the time of forming the first precursor layer 11 is preferably at least 0.1 vol%, more preferably at least 0.25 vol%. The upper limit of the flow ratio of the oxidizing sputtering gas may be 100 vol%.

On the other hand, the flow ratio of the oxidizing sputtering gas at the time of forming the second precursor layer 12, is preferably less than 0.1 vol%, more preferably at most 0.05 vol%. The lower limit of the flow ratio of the oxidizing sputtering gas may be 0 vol%.

Further, the sputtering gas at the time of forming the second precursor layer 12 may not contain the oxidizing sputtering gas, but may contain hydrogen (H$_2$) gas. In such a case, the flow ratio of hydrogen gas based on the total flow rate of the sputtering gas is preferably at least 1 vol% and at most 50 vol%. If the flow ratio of the hydrogen gas is smaller than the above range, the effect of adding hydrogen gas tends to be inadequate, and if it exceeds the above range, metallic titanium may be formed by excessive reduction.

Further, in a case where the target is made of a metal, in order to satisfy the above condition (1) or both conditions (1) and (2), the flow ratio of the oxidizing sputtering gas at the time of forming the precursor layer 11 is preferably at least 7.5 vol%, more preferably at least 10 vol%. The upper limit of the flow ratio of the oxidizing sputtering gas may be 100 vol%.

On the other hand, the flow ratio of the oxidizing sputtering gas at the time of forming the second precursor layer 12, is preferably within a range of from 3 vol% to 7.5 vol%, more preferably from 5 vol% to 7 vol%. If the flow ratio of the oxidizing sputtering gas is smaller than the above range, metallic titanium may be formed due to oxidation deficiency.

It is preferred that the concentration of the oxidizing sputtering gas in the atmosphere gas for forming the second precursor layer, is lower than the concentration of the oxidizing sputtering gas in the atmosphere gas for forming the first precursor layer, whereby it is possible to form a layer having high transparency and high electrical conductivity. Further, in such a case, it is preferred that the type of the respective oxidizing gases is the same.

[(B) CONTENT OF OXYGEN ATOMS IN TARGET]

In the case of the above method (B), with respect to the content of oxygen atoms in a target, by carrying out the film formation by using a metal target 21 and a metal oxide target 22 at the same time, it is possible to reduce the content of oxygen atoms in the targets to be used for the film formation, as compared with a case where film formation is carried out by using only the metal oxide target.

Specifically, both the metal target 21 and the metal oxide target 22 are preliminarily set in a vacuum chamber on the side facing the substrate 10. And, a voltage is applied to the metal target 21 and/or the metal oxide target 22, to carry out film formation on the substrate 10 while rotating the substrate 10. The content of a dopant in the metal target 21 and the metal oxide target 22 is preferably the same.

In this method, in a case where the concentration of the oxidizing sputtering gas in the atmosphere gas is constant, and the size of the metal target 21 and the metal oxide target 22 is the same, the oxygen content in the film tends to be small, as the proportion of "electric power supplied to the metal target/electric power applied to the metal oxide target" becomes large.

It is preferred that the content of oxygen atoms in the target to be used for forming the second precursor layer 12 is lower than the content of oxygen atoms in the target used for forming the first precursor layer 11, whereby it is possible to form a layer which has high transparency and high electrical conductivity. Further, in such a case, the dopant content in the respective targets is preferably the same.

For example, in a case where a metal oxide target 22 made of a metal oxide ($M:TiO_{2-\delta 2} : 0 \leqq \delta 2 \leqq 1.5$) and a metal target 21 made of an alloy of M and Ti, are used, and the gas flow ratio of the oxidizing sputtering gas at the time of forming the first precursor layer 11 and at the time of forming the second precursor layer 12 is made constant within a range of at least 0.1 vol%, it is preferred that at the time of forming the first precursor layer 11, as shown in Fig. 2(a), a voltage is applied only to the metal oxide target 22, and the voltage applied to the metal target 21 is made to be 0.

Then, at the time of forming the second precursor layer 12, as shown in Fig. 2(b), a voltage is applied to both the metal target 21 and the metal oxide target 22. For example, the discharge system for the metal oxide target is RF discharge, and the discharge system for the metal target is DC discharge, and in a case where the area of the targets is the same, in order to satisfy the above condition (1) or both conditions (1) and (2), the proportion of the electric power (unit: W) supplied to the metal target is preferably from 5 to 40%, based on the electric power (unit: W) supplied to the metal oxide target being 100%.

[LAYER THICKNESS]

In the precursor laminate 13, the first precursor layer 11 has a thickness T1 of preferably at least 5 nm and at most 50 nm, more preferably at least 10 nm and at most 40 nm. If the thickness is within the above range, it is possible to obtain a metal oxide layer 13' which has a low electrical resistance and is excellent in transparency. Further, good characteristics are obtainable also with respect to the carrier concentration and the hall mobility.

The thickness T2 of the second precursor layer 12 is not particularly limited so long as it is at least 5 nm, and it is preferably set depending upon the desired thickness of the metal oxide layer 13' after the annealing. From the following preferred thickness of the metal oxide layer 13', the thickness T2 of the second precursor layer 12 is preferably at least 15 nm. Here, the thickness (T1+T2) of the precursor laminate may sometimes decrease by from 0 to 10% after the annealing depending upon the production conditions. Accordingly, the thickness of the metal oxide layer 13' is usually thinner by from 0 to 10% than the thickness (T1+T2) of the precursor laminate 13.

The thickness of the metal oxide layer 13' obtained via the annealing is not particularly limited and may optionally be set depending upon the particular application, etc. For example, it is preferably from 20 to 1,000 nm, more preferably from 100 to 200 nm.

<ANNEALING STEP>

Via an annealing step of heating the precursor laminate 13 in a reducing atmosphere, a metal oxide layer 13' as an electrical conductor is formed.

It is preferred to heat the precursor laminate 13 from the first precursor layer 11 side, whereby better characteristics can be obtained with respect to the resistivity, carrier concentration and hall mobility. In this embodiment, the first precursor layer 11 is formed on the substrate 10, and the second precursor layer 12 is formed thereon, whereby it is preferred to heat the laminate from the substrate 10 side.

In the present invention, the reducing atmosphere means that the partial pressure of the oxidizing gas in the annealing atmosphere is at most $0.2 \times 10^5$ Pa. The oxidizing gas means a gas capable of presenting oxygen to the precursor laminate 13 in the annealing step, and a specific example may, for example, be $O_2$, $O_3$, NO, $NO_2$ or $H_2O$. In a case where two or more oxidizing gases are contained in the annealing atmosphere, the total of their partial pressure may be within the above range. The partial pressure of the oxidizing gas in the reducing atmosphere is preferably at most $1 \times 10^4$ Pa, more preferably at most 10 Pa. It is most preferably at a level of $1 \times 10^{-8}$ Pa. As the value of the partial pressure of the oxidizing gas is small, it is possible to obtain a metal oxide layer 13' having a lower electrical resistance.

In order to let the metal oxide layer 13' have a lower electrical resistance, it is preferred to let $H_2$ and/or CO be present in the reducing atmosphere, and it is more preferred to let $H_2$ be present in a plasma state. Accordingly, it is preferred that the annealing atmosphere is once evacuated to be a vacuum state and then, hydrogen ($H_2$) is introduced to carry out the annealing.

Further, it is also preferred that the reducing atmosphere to carry out the annealing is made to be a vacuum state.

In this specification, the atmosphere pressure in a vacuum state is within a range of from $10^3$ to $10^{-8}$ Pa, preferably within a range of $10^0$ to $10^{-8}$ Pa, more preferably within a range of from $10^{-2}$ to $10^{-8}$ Pa.

In the present invention, the annealing is an operation to raise the temperature to a predetermined level (to the annealing temperature) by heating and then lowering the temperature. In a case where the precursor laminate 13 is formed on a substrate 10 as in this embodiment, the substrate temperature may be applied as an annealing temperature.

The annealing temperature is set within a temperature range wherein each of the first precursor layer 11 and the second precursor layer 12 becomes a layer containing a polycrystal after the annealing. The crystal state of the metal oxide layer 13' after the annealing may be a polycrystal state or may be a state wherein amorphous and polycrystal are mixed. The amorphous structure usually has no birefringence, and therefore, the state wherein amorphous and polycrystal are mixed, is optically preferred.

In the annealing, the annealing temperature is specifically set to be a temperature higher than the higher one between the crystallization temperature of the first precursor layer 11 and the crystallization temperature of the second precursor layer 12. For example, the crystallization temperature of $TiO_2$ having no dopant incorporated is about 250°C, and if a dopant is incorporated, such a crystallization temperature tends to decrease. Accordingly, the annealing temperature is preferably at least 200°C although it depends also on the type of the dopant. On the other hand, if the annealing temperature is too high, the anatase type crystal structure is likely to be destroyed by the annealing step, whereby a good electrical conductive characteristics may not be obtained. Accordingly, it is preferably at most 900°C. The annealing temperature should better be low from the viewpoint of the heat resistance of the substrate 10, energy saving, shortening of the temperature raising time, etc. The annealing temperature is more preferably within a range of from 250 to 850°C, further preferably from 250 to 800°C.

The retention time (annealing time) at a prescribed annealing temperature is not particularly limited and may be optionally set so that desired characteristics can be obtained after the annealing. If the annealing temperature is low, the annealing time tends to be long. The annealing time is suitably at least 1 minute although it may depend on conditions other than the annealing temperature, and it is, for example, preferably within a range of from 1 to 120 minutes, more preferably from 1 to 60 minutes.

The second precursor layer 12 is formed to satisfy the above condition (1), and accordingly, when annealed with a single layer its crystal form will be a polycrystal containing a rutile type crystal. Nevertheless, when annealing is carried out in the form of the precursor laminate 13 having the first precursor layer 11 and the second precursor layer 12 laminated, formation of a rutile type crystal in the metal oxide layer 13' after the annealing, can be suppressed substantially. Particularly when the precursor laminate 13 is heated from the first precursor layer 11 side, the metal oxide layer 13' will be a polycrystal containing no rutile type crystal. This is a surprising phenomenon.

The second precursor layer 12 can be formed by adjusting the condition for the film formation to be a condition where the oxygen content in the film will be small. Further, while the first precursor layer 11 which satisfies the above condition (2) has high transparency, the second precursor layer 12 has a high absorption coefficient and is colored. Based on these facts, it is considered that the second precursor layer 12 contains substantial oxygen defects before the annealing.

On the other hand, in general, if oxygen defects are substantial in an amorphous film, a rutile type crystal is likely to be formed when it is heated at a temperature of at least the crystallization temperature, and an anatase type polycrystal tends to be hardly formed. Therefore, in the first precursor layer 11, oxygen defects are considered to be little. For example, when the above condition (1) or both conditions (1) and (2) is satisfied, oxygen atom vacancy in the second precursor layer 12 are considered to be at a level of from $1 \times 10^{18}$ to $1 \times 10^{20}/cm^{-3}$ as assumed from the carrier concentration in the $TiO_2$ thin film having no Nb incorporated, and the oxygen vacancy in the first precursor layer 11 are considered to be at a level of less than $1 \times 10^{18}/cm^{-3}$.

As compared with a metal oxide layer obtainable by annealing a single layer formed under the film forming conditions for the first precursor layer 11, the metal oxide layer 13' thus obtainable has the resistivity, carrier concentration and hall mobility remarkably improved, despite that it is the same from such a viewpoint that it is a polycrystal containing no rutile type crystal.

According to this embodiment, a metal oxide layer 13' having a low resistance and high transparency can be realized, and especially, a good transmittance in a visible light region can be obtained. Accordingly, it is suitable as an electrical conductor required to have transparency.

Further, in a case where a single crystal thin film M:TiO$_2$ having an anatase type crystal structure, disclosed in Patent Document 1, is formed by an epitaxial method, alignment of crystal in the substrate is regarded to be important, and control of the production conditions is also strict. However, according to the process of the present invention, an electrical conductor can be formed not only on the glass substrate, but also on a plastic surface or a silicon substrate such as an amorphous silicon substrate, whereby the range for selection of the substrate is wide, and the production is also easy. Thus, the process of the present invention presents good productivity, and the electrical conductor thereby obtainable has a broad range of applications.

As mentioned above, the precursor laminate is formed on a substrate by a sputtering method (first embodiment), but it may be formed by a PLD (pulse laser deposition) method (second embodiment).

In the PLD method, for example, in a chamber which is capable of maintaining a proper vacuum state, a substrate and a target are disposed to face each other; an oxygen gas is injected into the chamber, and the oxygen partial pressure in the chamber is maintained at a prescribed level; the substrate temperature is set at a prescribed level; while the substrate and the target are rotationally driven, a pulse laser beam is intermittently applied to the target to rapidly raise the temperature of the target surface thereby to let abrasion plasma be generated. Ti atoms, O atoms and M (dopant) atoms contained in the abrasion plasma undergo a collision reaction with oxygen gas in the chamber repeatedly to have their states gradually changed and move to the substrate, and upon arrival at the substrate, the particles including Ti atoms, M atoms and O atoms will spread over the surface of the substrate and will be formed into a thin film. In such a manner, a film is formed on the substrate.

As the above pulse laser beam, for example, a KrF excimer laser is employed which has a pulse frequency of from 1 to 10 Hz, a laser fluence (laser power) of from 1 to 2 J/cm$^2$ and a wavelength of 248 nm.

It is preferred that the pressure on the discharge side of the chamber is always maintained to be at most $10^{-3}$ torr ($1.33 \times 10^{-1}$ Pa), more preferably at most $10^{-4}$ torr ($1.33 \times 10^{-2}$ Pa).

[DOPANT]

In this embodiment, the substrate and the dopant are the same as in the first embodiment.

The target may, for example, be a metal oxide target. The metal oxide target is the same as in the first embodiment. Also in this embodiment, the content of the dopant in the target is substantially equal to the content of the dopant in the film to be formed by using such a target.

[SUBSTRATE TEMPERATURE]

The substrate temperature during the formation of the first precursor layer 11 and the second precursor layer 12 is the same as in the first embodiment.

Further, in the PLD method, the temperature range which the substrate temperature can take at the time of film formation without heating the substrate, i.e. the range of "room temperature" for the substrate temperature for the film formation, is from about 25 to 100°C, preferably from 25 to 50°C.

In this embodiment, the conditions to be satisfied by the first precursor layer 11 and the second precursor layer 12 are the same as the above conditions (1) and (2) in the first embodiment. The single layer annealing test is also the same except that the film forming method is different.

[(C) OXYGEN PARTIAL PRESSURE)

In this embodiment, as a method for controlling the oxygen content in the film in order to satisfy the above condition (1) or both conditions (1) and (2), (C) a method of controlling the oxygen partial pressure for the film formation is preferred as a method other than the above-mentioned methods (A) and (B).

In a case where the content of oxygen atoms in the target is constant, the oxygen content in the film decreases, as the oxygen partial pressure for the film formation decreases.

Specifically, in order to satisfy the above condition (1) or both conditions (1) and (2), for example, in a case where the target is made of a metal oxide (M:TiO$_{2-\delta3}$:$0 \leqq \delta3 \leqq 1.5$), the oxygen partial pressure for forming the first precursor layer 11 is preferably at least $5 \times 10^{-1}$ Pa, more preferably at least $1 \times 10^{\circ}$ Pa. Further, the upper limit of the oxygen partial pressure is $1 \times 10^5$ Pa from the viewpoint of the productivity.

On the other hand, the oxygen partial pressure at the time of forming the second precursor layer 12 is preferably less than $5 \times 10^{-1}$ Pa, more preferably at most $3 \times 10^{-1}$ Pa. The lower limit of the oxygen partial pressure is $1 \times 10^{-8}$ Pa

with a view to securing the transparency.

[LAYER THICKNESS]

In this embodiment, the thickness T1 of the first precursor layer 11, the thickness T2 of the second precursor layer 12 and the thickness of the metal oxide layer 13' after the annealing, are the same as in the first embodiment.

<ANNEALING STEP>

The precursor laminate 13 formed by the PLD method is heated in a reducing atmosphere for annealing, whereby a metal oxide layer 13' as an electrical conductor can be obtained.
The annealing step is the same as in the first embodiment.
Also in this embodiment, the same effect as in the first embodiment can be obtained.

<APPLICATIONS>

The electrical conductor of the present invention has a wide application range, and for example, its application to transparent electrodes for e.g. flat panel displays, solar cells or touch panels, is conceivable. Further, its application to a film to shield electromagnetic waves or to prevent dusts from attaching by static electricity to be used for an antireflection film, an antistatic film, a heat reflection glass or an ultraviolet reflection glass is conceivable. If a multilayer film comprising a layer made of $SiO_2$ and an Nb-doped $TiO_2$ layer is prepared, it may be applied as a reflection preventive film.
As examples of its application, applications to e.g. electrodes for dye-sensitized solar cells; transparent electrodes for e.g. display panels, organic EL panels, light emitting devices, light emitting diode (LED), white LED or lasers; transparent electrodes for surface emitting lasers; illumination devices; communication devices; and articles which permit only light within a specific wavelength range to pass, are conceivable.
Further, as specific applications, the following ones may be mentioned. For example, transparent electroconductive films in liquid crystal displays (LCD); transparent electroconductive films in color filters; transparent conductive films in EL (electro luminescence) displays; transparent conductive films in plasma displays (PDP); PDP optical filters; transparent electroconductive films for electromagnetic wave shielding; transparent electroconductive films for near infrared ray shielding; transparent electroconductive films to prevent surface reflection; transparent electroconductive films to improve color reproducibility; transparent electroconductive films to prevent breakage; optical filters; touch panels; resistance film type touch panels; electromagnetic induction type touch panels; ultrasonic type touch panels; optical touch panels; electrostatic capacitance touch panels; resistive touch panels for portable information terminals; touch panels integrated with displays (inner touch panels); solar cells; amorphous silicon (a-Si) type solar cells; microcrystal Si thin film solar cells; CIGS solar cells; dye-sensitized solar cells (DSC); antistatic transparent electroconductive materials for electronic components; antistatic transparent electroconductive materials; photochromic materials; photochromic mirrors; heating elements (surface heater, electrical heating glasses); and electromagnetic wave-shielding glasses, may, for example, be mentioned.

EXAMPLES

Now, the present invention will be described in further detail with reference to Examples, but it should be understood that the present invention is by no means restricted to such Examples.

<MEASURING METHODS>

In the following, the following methods are employed as the measuring methods. The measuring temperature was at room temperature (from 20 to 25°C) unless otherwise specified.

[TRANSMITTANCE, REFLECTANCE, ABSORPTANCE AND ABSORPTION COEFFICIENT]

The transmittance (%) and reflectance (%) were measured by a spectrophotometer manufactured by JEOL. The absorptance (%) was obtained by deducting the total of the transmittance and reflectance obtained by such measurements, from 100. That is, it was calculated by reflectance=100-transmittance-absorptance. The absorption coefficient was obtained by the above-described method.

[PROFILE BY X-RAY DIFFRACTION (XRD)]

The profile was measured by X-ray diffraction apparatus (XRD) manufactured by Bruker.

The following is an example wherein a sputtering method was used as the film forming method, and the "room temperature" for the substrate temperature is within a range of from 25°C to 80°C. In an actual experiment, film formation was carried out by a sputtering method under a condition where the substrate was not heated, whereby it was confirmed that the substrate temperature was within range of from 70°C to 80°C.

(EXAMPLE 1: ROOM TEMPERATURE FILM FORMATION; SINGLE LAYER; $O_2$ FLOW RATIO: 0 TO 5%)

The main production conditions are shown in Table 1. That is, by using a reactive DC magnetron sputtering device, an Nb added titanium oxide film was formed on a substrate. As the substrate, a non-alkali glass (product name: AN100, manufactured by Asahi Glass Company, Limited) having a thickness of 1 mm, was used. As the sputtering gas, a mixed gas of Ar gas and $O_2$ gas, was used.

That is, in a vacuum tank of the reactive DC magnetron sputtering device, a titanium oxide sintered body containing 4 atomic% of Nb was set as a metal oxide target, and a substrate was also set.

Then, the vacuum tank was evacuated to at most $5\times10^{-4}$ Pa by a pump, and then, Ar gas and $O_2$ gas were introduced into the vacuum system so that the $O_2$ flow ratio (oxidizing sputtering gas flow ratio) represented by $O_2(Ar+O_2)$ would be a prescribed value, and the pressure (sputtering pressure) in the vacuum tank was adjusted to be 1.0 Pa.

And, in such a state that a prescribed magnetic field was applied to the target, an electric power of 150 W was applied to the metal oxide target to form an Nb-doped titanium oxide film (precursor layer) on the substrate. No heating of the substrate was carried out, and the substrate temperature was room temperature. The film thickness was 100 nm.

Then, a single layer annealing test was carried out to obtain a sample having a metal oxide layer formed on the substrate. The obtained metal oxide layer had an Nb content of 4 atomic%.

At the time of forming the precursor layer, the $O_2$ flow ratio was changed in seven ways i.e. 0 vol%, 0.05 vol%, 0.25 vol%, 0.5 vol%, 1.0 vol%, 2.0 vol% and 5.0 vol%, to prepare the respective samples.

Each sample was confirmed to be amorphous before the annealing, by its XRD profile.

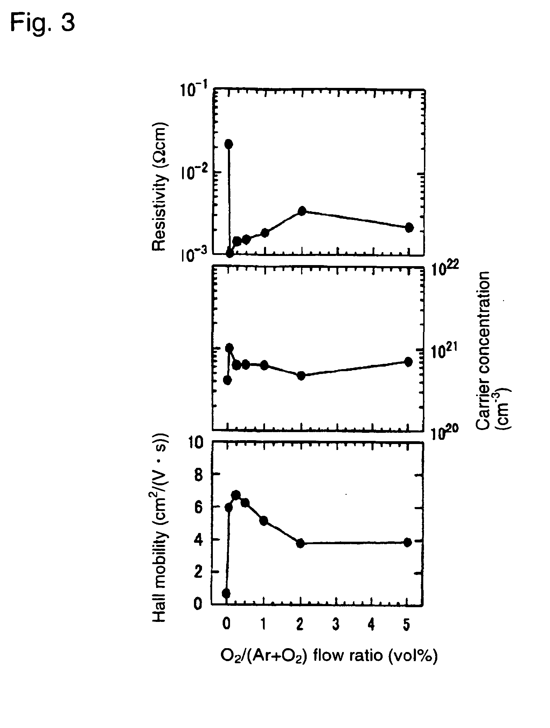

With respect to the metal oxide layer of each sample in a case where the $O_2$ flow ratio was from 0 to 5.0 vol%, the resistivity, carrier concentration and hall mobility were measured. The results are shown in Fig. 3.

In Fig. 3, the abscissa represents the $O_2$ flow ratio, and the ordinate represents the resistivity, carrier concentration or hall mobility. From the results in Fig. 3, it is evident that within the range of the $O_2$ flow ratio being from 0.05 to 5.0 vol%, the resistivity gradually decreases as the $O_2$ flow ratio decreases, but when the $O_2$ flow ratio becomes 0, the resistivity becomes substantially high.

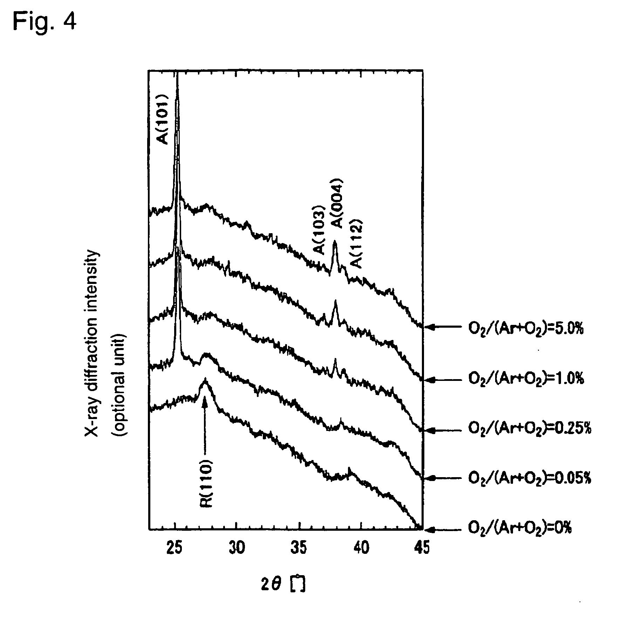

Further, X-ray diffraction was carried out with respect to the metal oxide layers after annealing, of the respective samples where the $O_2$ flow ratio was 0 vol%, 0.05 vol%, 0.25 vol%, 1.0 vol% and 5.0 vol% (hereinafter referred to as (Ex1-0%), (Ex1-0.05%), (Ex1-0.25%), (Ex1-1%) and (Ex1-5%)), respectively. The obtained XRD profiles are shown in Fig. 4. In Fig. 4, in (Ex1-0.25%), (Ex1-1%) and (Ex1-5%), (101) peak and (005) peak characteristic to an anatase type crystal are observed, and no (110) peak characteristic to a rutile type crystal is observed. Whereas, in (Ex1-0.05%), a (110) peak of a rutile type crystal is observed together with (101) and (004) peaks of an anatase type crystal, thus indicating that it is a polycrystal wherein an anatase type crystal and a rutile type crystal are mixed. Further, in (Ex1-0%), (101) and (004) peaks are not observed, and a (110) peak is observed.

These results show that (Ex1-0%) and (Ex1-0.05%) are amorphous layers before annealing, and after the single layer annealing tests, they become layers containing polycrystals which contain rutile type crystal. That is, (Ex1-0%) and (Ex1-0.05%) satisfy the above condition (1) with respect to the second precursor layer of the present invention.

Further, (Ex1-0.25%), (Ex1-1%) and (Ex1-5%) are amorphous layers before annealing and after the single layer annealing tests, they become layers which contain polycrystals which contain no rutile type crystal. That is, they satisfy the above condition (1) with respect to the first precursor in the present invention.

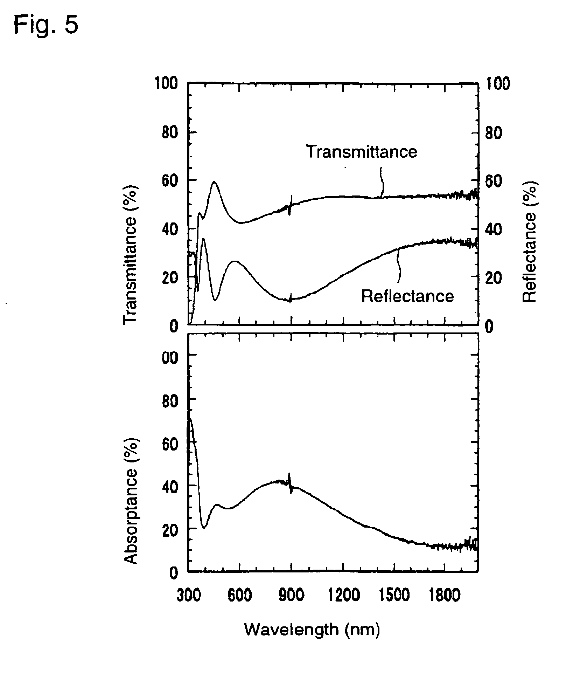

Fig. 5 is graphs showing the results of measurement of the transmittance T, reflectance R and absorptance with respect to the film before annealing, of (Ex1-0%). The abscissa represents the wavelength. From the results, the absorption coefficient at a wavelength of 800 nm was $3.40\times10^{-4}$ cm$^{-1}$. Thus, the sample of (Ex1-0%) satisfies the above condition (2) with respect to the second precursor layer in the present invention. Further, the metal oxide layer of this sample was visually observed and was found to be colored.

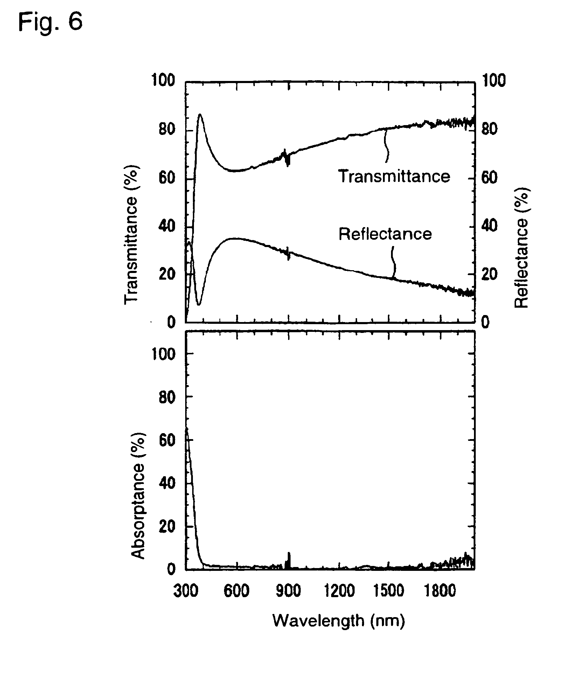

Fig. 6 is graphs showing the results of measurement of the transmittance T, reflectance R and absorptance, with respect to the film before annealing, of (Ex1-1 %). From the results, the absorption coefficient at the wavelength of 800 nm was $3.58\times10^{3}$ cm$^{-1}$. Here, Fig. 6 shows the data with a layer thickness of 60 nm, but the value of the absorption coefficient is not influenced by the layer thickness. Thus, (Ex1-1%) satisfies the above condition (2) with respect to the first precursor layer in the present invention.

(EXAMPLE 2: ROOM TEMPERATURE FILM FORMATION; PRECURSOR LAMINATE; HEATING FROM FIRST PRECURSOR LAYER SIDE)

The main production conditions are shown in Table 1. That is, in Example 1, a first precursor layer was formed on a substrate under the same film forming conditions as for (Ex1-1 %) which was confirmed to satisfy the above conditions (1) and (2) with respect to the first precursor layer. The substrate was the same as in Example 1. However, the layer thickness was 30 nm.

Then, the second precursor layer was formed thereon under the same film forming conditions for (Ex1-0%) which was confirmed to satisfy the above conditions (1) and (2) with respect to the second precursor layer in Example 1. However, the layer thickness was 170 nm.

The precursor laminate thus obtained, was subjected to annealing under the same conditions as the single layer annealing test to obtain a sample having a metal oxide layer formed on the substrate. Heating during the annealing was carried out from the first precursor layer side by a method of contacting a heating element to the substrate.

TABLE 1

|  | Example 1 | Example 2 | |
|---|---|---|---|
|  |  | First precursor layer | Second precursor layer |
| Substrate | Non-alkali glass plate | Non-alkali glass plate | |
| Target | Nb:TiO$_2$ sintered body containing 4 atomic% of Nb | Nb:TiO$_2$ sintered body containing 4 atomic% of Nb | Same as shown left |
| Sputtering gas | Mixed gas of O$_2$ and Ar | Mixed gas of O$_2$ and Ar | Same as shown left |
| O$_2$ flow ratio | 0 to 5 vol% | 1.0 vol% | 0 vol% |
| Substrate temperature during film formation | Room temperature | Room temperature | Same as shown left |
| Sputtering pressure | 1.0 Pa | 1.0 Pa | Same as shown left |
| Magnetron magnetic field intensity | 250 G | 250 G | Same as shown left |
| Electric power applied to target | 150 nW | 150 W | Same as shown left |
| Layer thickness before annealing | 100 nm | 30 nm | 170 nm |
| Annealing conditions | Same as in single layer annealing test | Same as in single layer annealing test | |
| Heatinq direction | Single layer annealing | Heating from first precursor layer side | |
| Measured results | Fig. 3, Fig. 4, Fig. 5, Fig. 6 | Fig. 7, Fig. 8, Fig. 10, Fig. 11 | |

(EXAMPLE 3: ROOM TEMPERATURE FILM FORMATION; PRECURSOR LAMINATE; HEATING FROM SECOND PRECURSOR LAYER SIDE)

In Example 2, the lamination order of the first precursor layer and the second precursor layer was changed, and the heating for annealing was carried out from the second precursor layer side by a method of contacting a heating element to the substrate.

That is, firstly, on a substrate, a second precursor layer (thickness: 170 nm) was formed under the same film forming conditions as for (Ex1-0%), and a first precursor layer (thickness: 30 nm) was formed thereon under the same film forming conditions as for (Ex1-1%). The substrate was the same as in Example 1.

The precursor laminate thus obtained was heated from the substrate side under the same conditions as in the single layer annealing test, to carry out annealing thereby to obtain a sample having a metal oxide layer formed on the substrate.

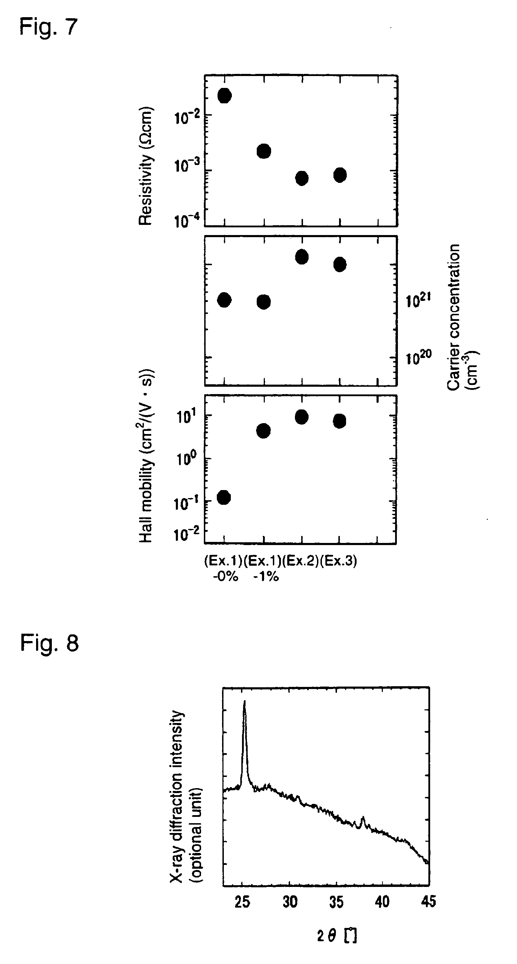

With respect to the metal oxide layers obtained in Examples 2 and 3, the resistivity, carrier concentration and hall mobility were measured. The results are shown in Fig. 7. Further, for the purpose of comparison, the measured results with respect to the metal oxide layers of the sample of (Ex1-0%) and the sample of (Ex1-1%) obtained in Example 1, are also shown. From the results of this Fig., it is evident that as compared with the samples of (Ex1-0%) and (Ex1-1%) annealed in a single layer state, in Examples 2 and 3 wherein they are annealed as laminated, a substantial improvement was observed in each of the resistivity, carrier concentration and hall mobility. Further, Example 2 was superior to Example 3 in these characteristics. The resistivity of the metal oxide layer is preferably at most $1 \times 10^{-3}$ Ωcm.

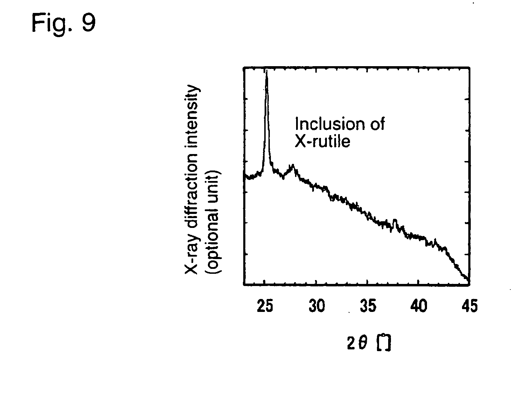

Further, Figs. 8 and 9 show the measured results (XRD profiles) obtained by carrying out X-ray diffraction with respect to the metal oxide layers of the samples obtained in Examples 2 and 3, respectively.

As shown in Fig. 8, with the sample of Example 2, (101) and (004) peaks characteristic to an anatase type crystal are observed, and a (110) peak characteristic to a rutile type crystal is not observed.

It is thereby evident that in spite of the fact that in the second precursor layer in Example 2, most of crystal formed in the single layer annealing test is a rutile type crystal (see Fig. 4), when such a layer is laminated on the first precursor layer, and annealing is carried out by heating from the first precursor layer side, a polycrystal which contains no rutile type crystal, will be formed.

As shown in Fig. 9, with the sample of Example 3, a (110) peak characteristic to a rutile type crystal is observed as well as (101) and (004) peaks characteristic to an anatase type crystal. That is, in the sample of Example 3 heated from the second precursor layer side for annealing, not only an anatase type crystal but also a rutile type crystal is present as mixed.

It is thereby evident that in spite of the fact that in the second precursor layer in Example 3, most of crystal formed in the single layer annealing test is a rutile type crystal (see Fig. 4), when this layer is laminated below the first precursor layer, and annealing is carried out by heating from the second precursor layer side, an anatase type crystal and a rutile type crystal will be present in a mixed state. Formation of a rutile type crystal by annealing in such a second precursor layer is little as compared with the single layer annealing test, and it is evident that by annealing a laminate of the first precursor layer and the second precursor layer, formation of a rutile type crystal is substantially suppressed.

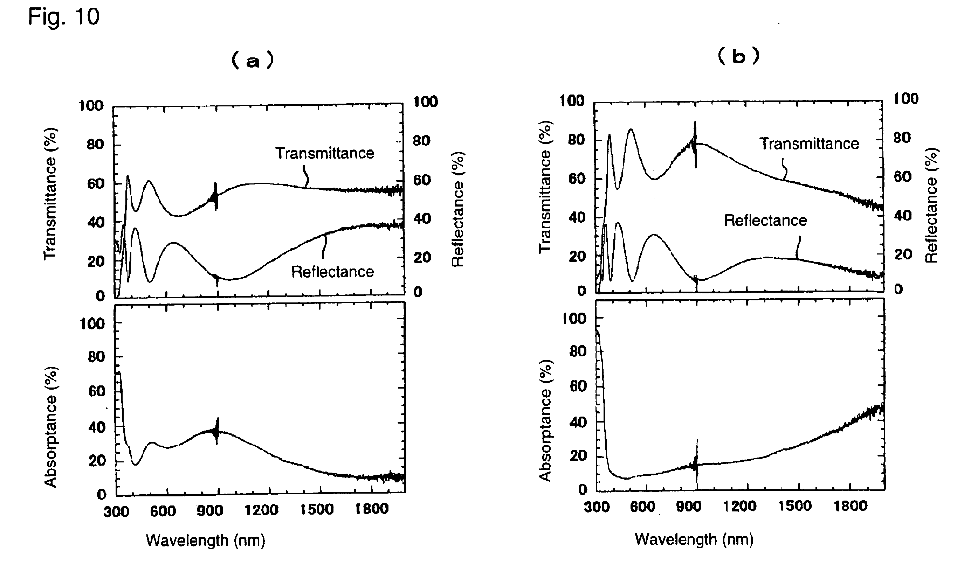

Fig. 10 is graphs showing the results of measurement of the transmittance T, reflectance R and absorptance with respect to the precursor laminate before annealing and the metal oxide layer after annealing in Example 2. Fig. 10(a) shows the results before annealing, and Fig. 10(b) shows the results after annealing. As shown in Fig.10(a), the precursor laminate before annealing has high absorptance in a visible light region. This is considered attributable to the fact that the second precursor layer has a high absorption coefficient and is colored. Whereas, with the metal oxide layer after annealing (Fig. 10(b)), the absorptance decreased, and the transparency was improved.

The minimum transmittance in the visible light region of the metal oxide layer is preferably at least 50%.

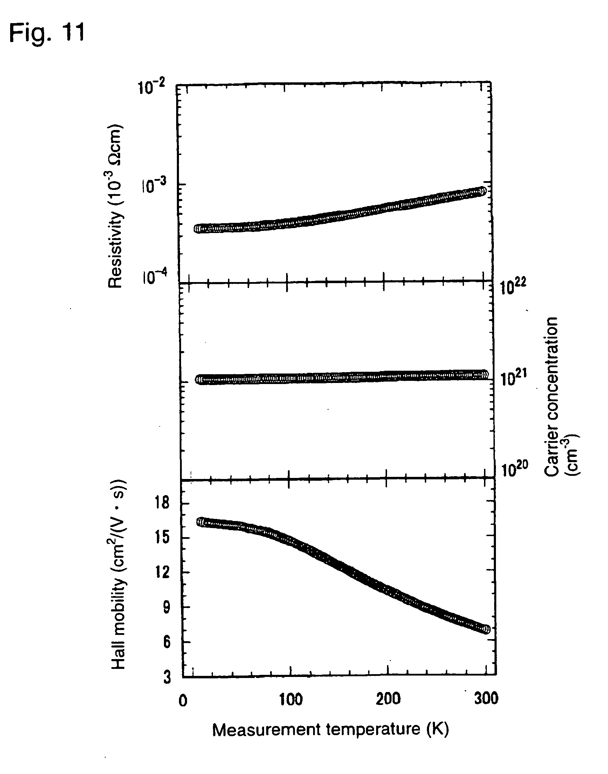

Fig. 11 is graphs showing the results of measuring the resistivity, carrier concentration and hall mobility with respect to the metal oxide layer after annealing obtained in Example 2, while changing the measurement temperature within a range of from 10 to 300 K. The abscissa represents the measurement temperature. From the results in Fig. 11, it is evident that in the metal oxide layer obtained in Example 2, the carrier concentration is substantially constant even if the temperature is changed, thus showing a metallic electrical conductivity characteristic.

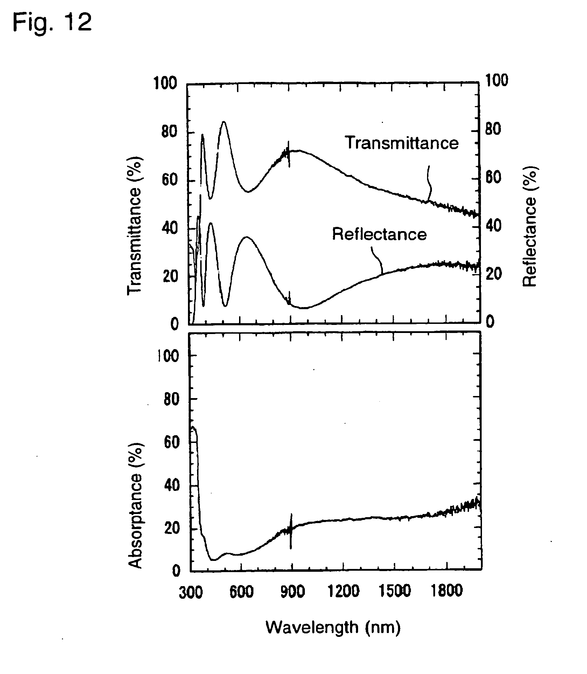

Fig. 12 is graphs showing the results of measuring the transmittance T, reflectance R and absorptance with respect to the metal oxide layer after annealing in Example 3. The optical characteristics before annealing were the same as in Example 2. As shown in Fig. 12, the metal oxide layer after annealing had a low absorptance and good transparency.

(EXAMPLE 4: ROOM TEMPERATURE FILM FORMATION; PRECURSOR LAMINATE; HEATING FROM FIRST PRECURSOR LAYER SIDE; LAYER THICKNESS DEPENDENCY)

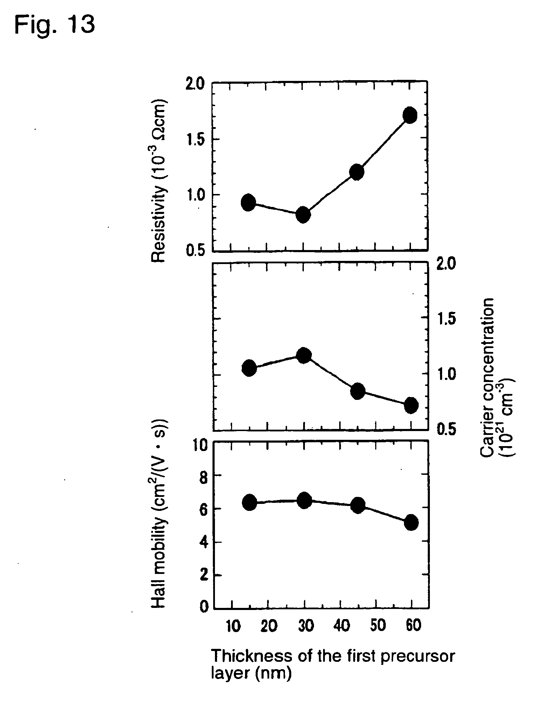

In Example 2, the thickness of the first precursor layer was changed within a range of from 15 to 60 nm. Otherwise, in the same manner as in Example 2, a sample having a metal oxide layer formed on a substrate was obtained. With respect to the obtained metal oxide layer, the resistivity, carrier concentration and hall mobility were measured. The results are shown in Fig. 13. The abscissa represents the thickness of the first precursor layer.

From the results in Fig. 13, it is evident that the thickness of the first precursor layer gives an influence over the electrical characteristics of the metal oxide layer after annealing. When the thickness of the first precursor layer is within a range of from 15 to 30 nm, it was distinctly excellent in the resistivity and carrier concentration.

(EXAMPLE 5: ROOM TEMPERATURE FILM FORMATION; HEATING FROM FIRST PRECURSOR LAYER SIDE; $O_2$ FLOW RATIO DEPENDENCY)

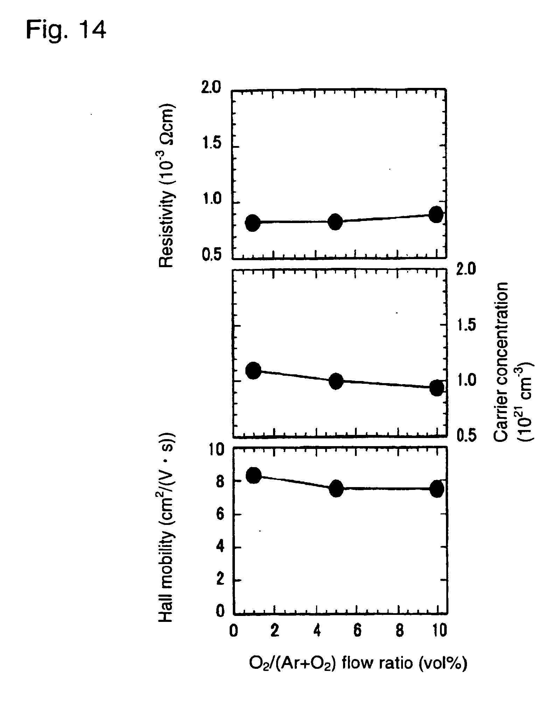

In Example 2, the $O_2$ flow ratio at the time of forming the first precursor layer was changed within a range of form 1 vol% to 10 vol%. Otherwise, in the same manner as in Example 2, a sample having a metal oxide layer formed on a substrate was obtained. With respect to the obtained metal oxide layer, the resistivity, carrier concentration and hall mobility were measured. The results are shown in Fig. 14. The abscissa represents the $O_2$ flow ratio at the time of forming the first precursor layer.

From the results in Fig. 14, it is evident that within the range of this Example, the influence of the $O_2$ flow ratio at the time of forming the first precursor layer over the electrical characteristics of the metal oxide layer, is small.

(EXAMPLE 6: ROOM TEMPERATURE FILM FORMATION; SINGLE LAYER; COMBINED USE OF TWO TYPES OF TARGETS)

The main film forming conditions are shown in Table 2. In this Example, as shown in Fig. 2, in a reactive CD magnetron sputtering apparatus, a metal target 21 made of a Ti-Nb alloy containing 4 atomic% of Nb and the same metal oxide target 22 as in Example 1 were set at the same time, and an Nb-added titanium oxide film was formed on a substrate.

As the substrate, the same non-alkali glass as in Example 1 was used. As the sputtering gas, a mixed gas of Ar gas and $O_2$ gas was used.

That is, in a vacuum tank of a reactive DC magnetron sputtering apparatus, the metal target 21 and the metal oxide target 22 are set, and at the same time, the substrate 10 was set.

Then, the vacuum tank was evacuated to at most $5\times10^{-4}$ Pa by a pump, and the, Ar gas and $O_2$ gas were introduced into the vacuum system so that the $O_2$ flow ratio (oxidizing sputtering gas flow ratio) represented by $O_2/(Ar+O_2)$ would be 1.0 vol%, and the pressure (sputtering pressure) in the vacuum tank was adjusted so that it would be 1.0 Pa.

And, in such a state that a prescribed magnetic field was applied to the target, an electric power of 150 W was applied to the metal oxide target to form an Nb-doped titanium oxide film (precursor layer) on the substrate 10. An electric power was not applied to the metal target 21. No heating of the substrate was carried out, and the substrate temperature was room temperature. The layer thickness was 100 nm. It was confirmed by the XRD profile that the obtained film before annealing was in an amorphous state.

Then, a single layer annealing test was carried out to obtain a sample having a metal oxide layer formed on a substrate. The Nb content in the obtained metal oxide layer was 4 atomic%.

With respect to the metal oxide layer after annealing obtained in this Example, the resistivity, carrier concentration, hall mobility and XRD profile were measured. Further, the transmittance T and the reflectance R as well as the absorptance were measured, and the absorption coefficient at a wavelength of 800 nm was obtained. Each result was equal to the result in (Ex1-1%).

From the above, it is evident that the film before annealing in this Example satisfies the above conditions (1) and (2) with respect to the first precursor in the present invention.

(EXAMPLE 7: ROOM TEMPERATURE FILM FORMATION; SINGLE LAYER; COMBINED USE OF TWO TYPES OF TARGETS)

The main film forming conditions are shown in Table 2. That is, in Example 6, at the same time as applying an electric power of 150 W to a metal oxide target 22, an electric power of 40 W was applied to a metal target 21, and otherwise in the same manner as in Example 6, an Nb-doped titanium oxide film (second precursor layer) was formed on the first precursor layer. Without heating the substrate, the substrate temperature was set to be room temperature. The thickness of the second precursor layer was 100 nm. It was confirmed by the XRD profile that the obtained film before annealing was in an amorphous state.

Then, a single layer annealing test was carried out to obtain a sample having a metal oxide layer formed on a substrate. The obtained metal oxide layer had an Nb content of 4 atomic%.

With respect to the metal oxide layer of the sample obtained in this Example, the resistivity, carrier concentration, hall mobility and XRD profile were measured. Further, the transmittance T, reflectance R and absorptance were measured, and the absorption coefficient at a wavelength of 800 nm was obtained. Each result was equal to the result of (Ex1-0%).

From the foregoing, it is evident that the film before annealing in this Example satisfies the above conditions (1) and (2) with respect to the second precursor layer in the present invention.

TABLE 2

|  | Example 6 | Example 7 |
| --- | --- | --- |
| Substrate | Non-alkali glass plate | Same as shown left |
| Target | Metal oxide (sintered body) and metal (alloy) | Same as shown left |
| Sputtering gas | Mixed gas of $O_2$ and Ar | Same as shown left |

(continued)

| | Example 6 | Example 7 |
|---|---|---|
| O$_2$ flow ratio | 1.0 vol% | Same as shown left |
| Substrate temperature during film formation | Room temperature | Same as shown left |
| Sputtering pressure | 1.0 Pa | Same as shown left |
| Magnetron magnetic field intensity | Metal oxide: 250 G Metal: 1,000 G | Same as shown left |
| Electric power applied to target | Metal oxide: 150 W Metal: 0 W | Metal oxide: 150 W Metal: 40 W |
| Layer thickness before annealing | 100 nm | 100 nm |
| Annealing conditions | Same as in single layer annealing test | Same as shown left |
| Heating direction | Single layer annealing | Same as shown left |

(EXAMPLE 8: ROOM TEMPERATURE FILM FORMATION; PRECURSOR LAMINATE; COMBINED USE OF TWO TYPES OF TARGETS; HEATING FROM THE FIRST PRECURSOR LAYER SIDE)

A first precursor layer was formed on a substrate under the same film forming conditions as in Example 6 which was confirmed to satisfy the above conditions (1) and (2) with respect to the first precursor layer. The substrate was the same as in Example 1. However, the layer thickness was 30 nm.

Then, a second precursor layer was formed thereon under the same film forming conditions as in Example 7 which was confirmed to satisfy the above conditions (1) and (2) with respect to the second precursor layer. However, the layer thickness was 170 nm.

The precursor laminate thus obtained was subjected to annealing under the same conditions as in the single layer annealing test to obtain a sample having a metal oxide layer formed on a substrate. Heating for annealing was carried out from the first precursor layer side by a method of contacting a heating element to the substrate.

With respect to the metal oxide layer of the sample obtained in this Example, the resistivity, carrier concentration, hall mobility and XRD profile were measured. Further, before annealing and after annealing, the transmittance T, reflectance R and absorptance were measured, respectively. Each result was equal to the result in Example 2.

Thus, it was ascertained that an electrical conductor of the present invention can be produced satisfactorily also in a method wherein a metal oxide target and a metal target are used in combination in a sputtering method.

(EXAMPLE 9: ANNEALING AFTER ROOM TEMPERATURE FILM FORMATION; SINGLE LAYER)

On the same substrate as in Example 1, a film of an amorphous state was formed under the same film forming conditions as for (Ex1-1%), followed by annealing under the same conditions as for the single layer annealing test to obtain a precursor layer. The layer thickness was 100 nm. Such a precursor layer after annealing corresponds to a metal oxide layer after the single layer annealing test in (Ex1-1%) and is a layer containing a polycrystal which contains no rutile type crystal.

This precursor layer contains no rutile type crystal, and therefore, when subjected to a single layer annealing test, it becomes a layer containing a polycrystal which contains no rutile type crystal. Thus, the precursor layer (after annealing) of this Examples satisfies the above condition (1) with respect to the first precursor layer in the present invention.

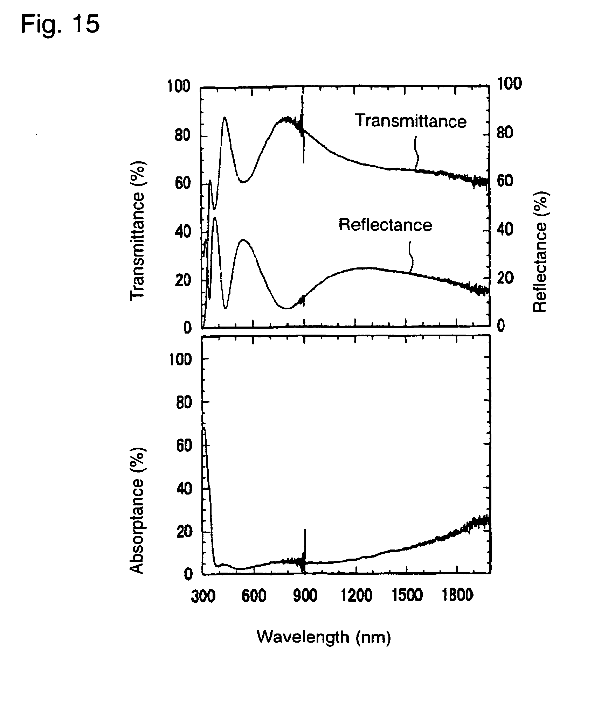

Further, the results of measurement of the transmittance, reflectance and absorptance of the precursor layer (after annealing) of this Example are shown in Fig. 15. From the results, the absorption coefficient was $3.96 \times 10^3$ cm$^{-1}$. Here, Fig. 15 is data with a layer thickness of 170 nm, but the value of the absorption coefficient is not influenced by the layer thickness. Thus, the precursor layer in this Example satisfies the above condition (2) with respect to the first precursor layer in the present invention.

(EXAMPLE 10: ANNEALING AFTER ROOM TEMPERATURE FILM FORMATION; PRECURSOR LAMINATE)

On the same substrate as in example 1, a first precursor layer was formed in the same manner as in Example 9. However, the layer thickness was 30 nm. Then, a second precursor layer was formed thereon under the same film forming conditions as for (Ex1-0%) which was confirmed to satisfy the above conditions (1) and (2) with respect to the second precursor layer in Example 1. However, the layer thickness was 170 nm.

The precursor laminate thus obtained was subjected to annealing under the same conditions as in the single layer annealing test to obtain a sample having a metal oxide layer formed on the substrate. Heating for annealing was carried out from the first precursor layer side by a method of contacting a heating element to the substrate.

With respect to the metal oxide layer obtained in this Example, the resistivity, carrier concentration and hall mobility were measured, whereby the resistivity was $1.3\times10^{-4}$ $\Omega$cm, the carrier concentration was $1.1\times10^{21}$ cm$^{-3}$, and the hall mobility was $4.3\times$cm$^2$/(V·s). This indicates that the annealed precursor layer containing a polycrystal is also effective to reduce the electrical resistance.

Further, with respect to the metal oxide obtained in this Example, X-ray diffraction was carried out, whereby the results equal to Fig. 8 were obtained. Further, with respect to the metal oxide layer after annealing, the transmittance T and reflectance R were measured, whereby the results equal to Fig. 10(b) were obtained. From these results, it is evident that the metal oxide obtained in this Example is a layer containing a polycrystal which contains no rutile type crystal and is excellent in transparency.

Thus, even when the first precursor layer is not an amorphous layer but a layer containing a polycrystal which contains no rutile type crystal, it is possible to satisfactorily produce an electrical conductor of the present invention.

(EXAMPLE 11: ROOM TEMPERATURE FILM FORMATION; PRECURSOR LAMINATE; ANNEALING AT 400°C)

The main production conditions are shown in Table 3. That is, a first precursor layer was formed on a substrate under the same film forming conditions as for (Ex1-5%) which was confirmed to satisfy the above condition (1) with respect to the first precursor layer in Example 1. The substrate was a non-alkali glass (product name: #1737, manufactured by Corning) having a thickness of 1.1 mm. However, the layer thickness was 30 nm.

Then, a second precursor layer was formed thereon under the same film forming conditions as for (Ex1-0.05%) which was confirmed to satisfy the above condition (1) with respect to the second precursor in Example 1. However, the layer thickness was 170 nm.

The precursor laminate thus obtained was subjected to annealing to obtain a sample having a metal oxide layer formed on the substrate. The annealing conditions are as follows. Firstly, the annealing atmosphere was once evacuated to a vacuum of $10^{-2}$ Pa, and then, hydrogen (H$_2$) was introduced to make an atmosphere of 100% H$_2$. The atmosphere pressure at that time was adjusted to $1.013\times10^5$ Pa (1 atm). Then, in such an H$_2$ atmosphere, the substrate was heated by contacting a heating element to the rear side of the substrate so that the substrate temperature reached 400°C from room temperature (about 25°C) in 5 minutes. And, the sample was maintained at 400°C for 1 hour and then left to cool to room temperature.

With respect to a metal oxide layer thus obtained, the resistivity was measured and found to be $7.3\times10^{-4}$ $\Omega$cm. From this Example, it is evident that a metal oxide layer having a low resistance can be obtained at an annealing temperature of 400°C.

(EXAMPLE 12: ROOM TEMPERATURE FILM FORMATION; PRECURSOR LAMINATE; ANNEALING IN VACUUM AT 400°C)

The main production conditions are shown in Table 3. That is, a sample having a metal oxide layer formed on a substrate was obtained in the same manner as in Example 11 except that the annealing was carried out in a vacuum atmosphere ($10^{-2}$ Pa).

With respect to the metal oxide layer thus obtained, the resistivity was measured and found to be $7.4\times10^{-4}$ $\Omega$cm.

From this Example, it is evident that it is possible to obtain a metal oxide layer having a low resistance even when annealing is carried out in vacuum at an annealing temperature of 400°C.

(EXAMPLE 13: ROOM TEMPERATURE FILM FORMATION; PRECURSOR LAMINATE; SODA LIME SUBSTRATE)

The main production conditions are shown in Table 3. That is, a sample having a metal oxide layer formed on a substrate was obtained in the same manner as in Example 11 except that the substrate was changed to a glass plate having a thickness of 1.1 mm made of soda lime glass.

With respect to the metal oxide layer thus obtained, the resistivity was measured and found to be $7.2\times10^{-4}$ $\Omega$cm,

From this Example, it is evident that it is possible to obtain a metal oxide layer having a low resistance at an annealing temperature of 400°C even when the substrate is made of soda lime glass.

(EXAMPLE 14: ROOM TEMPERATURE FILM FORMATION; PRECURSOR LAMINATE; POLYIMIDE FILM SUBSTRATE)

The main production conditions are shown in Table 3. That is, a sample having a metal oxide layer formed on a substrate was obtained in the same manner as in Example 11 except that the substrate was changed to a polyimide film having a thickness of about 100 $\mu$m.

With respect to the metal oxide layer thus obtained, the resistivity was measured and found to be $3.1 \times 10^{-3}$ $\Omega$cm.

From this Example, it is evident that it is possible to obtain a metal oxide layer having a low resistance at an annealing temperature of 400°C also when the substrate is a film made of polyimide.

TABLE 3

| | Example 11 | | Example 12 | | Example 13 | | Example 14 | |
|---|---|---|---|---|---|---|---|---|
| | First precursor layer | Second precursor layer | First precursor layer | Second precursor layer | First precursor layer | Second precursor layer | First precursor layer | Second precursor layer |
| Substrate | Non-alkali glass plate | | Non-alkali glass plate | | Soda lime glass plate | | Polyimide film | |
| Target | Nb:TiO$_2$ sintered body containing 4 atomic% of Nb | Same as shown left | Same as shown left | Same as shown left | Same as shown left | Same as shown left | Same as shown left | Same as shown left |
| Sputtering gas | Mixed gas of O$_2$ and Ar | Same as shown left | Same as shown left | Same as shown left | Same as shown left | Same as shown left | Same as shown left | Same as shown left |
| O$_2$ flow ratio | 5.0 vol% | 0.05 vol% | 5.0 vol% | 0.05 vol% | 5.0 vol% | 0.05 vol% | 5.0 vol% | 0.05 vol% |
| Substrate temperature during film formation | Room temperature | Same as shown left | Same as shown left | Same as shown left | Same as shown left | Same as shown left | Same as shown left | Same as shown left |
| Sputtering pressure | 1.0 Pa | Same as shown left | Same as shown left | Same as shown left | Same as shown left | Same as shown left | Same as shown left | Same as shown left |
| Magnetron magnetic field intensity | 250 G | Same as shown left | Same as shown left | Same as shown left | Same as shown left | Same as shown left | Same as shown left | Same as shown left |
| Electric power applied to target | 150W | Same as shown left | Same as shown left | Same as shown left | Same as shown left | Same as shown left | Same as shown left | Same as shown left |
| Layer thickness before annealing | 30 nm | 170 nm | 30 nm | 170 nm | 30 nm | 170 nm | 30 nm | 170 nm |
| Annealing conditions | Hydrogen 100%, 1 atm, 400°C, 1 hr | | Vacuum ($10^{-2}$ Pa) 400°C, 1 hr | | Hydrogen 100%, 1 atm, 400°C, 1 hr | | Hydrogen 100%, 1 atm, 400°C, 1 hr | |
| Heating direction | Heating from first precursor side | | Heating from first precursor side | | Heating from first precursor side | | Heating from first precursor side | |

(continued)

| Substrate | Non-alkali glass plate | Non-alkali glass plate | Soda lime glass plate | Polyimide film |
|---|---|---|---|---|
| Resistivity | $7.3 \times 10^{-4}$ Ωcm | $7.4 \times 10^{-4}$ Ωcm | $7.2 \times 10^{-4}$ Ωcm | $3.1 \times 10^{-3}$ Ωcm |

According to the present invention, a metal oxide layer made of titanium oxide containing metal atoms as a dopant can be realized, and it is possible to provide an electrical conductor having a low resistance, high transparency and good transmittance in a visible light region. Such an electrical conductor may be applied to e.g. transparent electrodes in flat panel displays, solar cells or touch panels, or films to shield electromagnetic waves or to prevent dusts from attaching by static electricity, to be used for anti-reflection films, antistatic films, heat reflection glasses or ultraviolet reflection glasses.

**Claims**

1.  A process for producing an electrical conductor, which comprises a laminate-forming step of forming a precursor laminate having a first precursor layer and a second precursor layer laminated in an optional order on a substrate, and an annealing step of heating the precursor laminate in a reducing atmosphere for annealing to form a metal oxide layer from the first precursor layer and the second precursor layer, wherein:

    the first precursor layer is a titanium oxide layer made of titanium oxide containing at least one dopant selected from the group consisting of Nb, Ta, Mo, As, Sb, Al, Hf, Si, Ge, Zr, W, Co, Fe, Cr, Sn, Ni, V, Mn, Tc, Re, P and Bi, and the titanium oxide layer is a titanium oxide layer which, when subjected to a single layer annealing test, becomes a titanium oxide layer containing a polycrystal which is free from a rutile type crystal, and
    the second precursor layer is an amorphous titanium oxide layer made of titanium oxide containing at least one dopant selected from the above group, and the amorphous titanium oxide layer is an amorphous titanium oxide layer which, when subjected to a single layer annealing test, becomes a titanium oxide layer containing a polycrystal which contains a rutile type crystal,
    wherein the single layer annealing test on the first precursor layer and the second precursor layer is carried out by the procedure as indicated in the description.

2.  The process for producing an electrical conductor according to claim 1, wherein
    the first precursor layer has an absorption coefficient of larger than 0 cm$^{-1}$ and less than $2\times10^4$ cm$^{-1}$ at a wavelength of 800 nm, and
    the second precursor layer has an absorption coefficient of at least $2\times10^4$ cm$^{-1}$ and less than $5\times10^4$cm$^{-1}$ at a wavelength of 800 nm.

3.  The process for producing an electrical conductor according to Claim 1 or 2, wherein the content of dopant atoms in each of the first precursor layer and the second precursor layer is at least 1 atomic % and at most 10 atomic % based on the total amount of dopant atoms and titanium atoms.

4.  The process for producing an electrical conductor according to any one of Claims 1 to 3, wherein the first precursor layer has a thickness of at least 5 nm and at most 50 nm, the second precursor layer has a thickness of at least 15 nm, and the metal oxide layer has a thickness of from 20 to 1,000 nm.

5.  The process for producing an electrical conductor according to any one of Claims 1 to 4, wherein the laminate-forming step has steps of forming the first precursor layer and the second precursor layer, respectively, by a sputtering method, and the concentration of an oxidizing sputtering gas in an atmosphere gas for forming the second precursor layer is lower than the concentration of the oxidizing sputtering gas in an atmosphere gas for forming the first precursor layer.

6.  The process for producing an electrical conductor according to any one of Claims 1 to 5, wherein the laminate-forming step has steps of forming the first precursor layer and the second precursor layer, respectively, by a sputtering method, and the content of oxygen atoms in a target used for forming the second precursor layer is lower than the content of oxygen atoms in a target used for forming the first precursor layer.

7.  The process for producing an electrical conductor according to any one of Claims 1 to 6, wherein in the annealing step, the precursor laminate is heated in a hydrogen atmosphere or in a vacuum atmosphere.

8.  The process for producing an electrical conductor according to any one of Claims 1 to 7, wherein in the annealing step, the precursor laminate is held at a temperature of from 250 to 850°C for at least one minute.

9.  The process for producing an electrical conductor according to any one of Claims 1 to 8, wherein in the annealing

22

**EP 2 128 876 B1**

step, the precursor laminate is heated from the first precursor layer side.

**Patentansprüche**

1. Verfahren zur Herstellung eines elektrischen Leiters, welches einen Laminatbildungsschritt des Bildens eines Vorläuferlaminats mit einer ersten Vorläuferschicht und einer zweiten Vorläuferschicht, laminiert in einer optionalen Reihenfolge auf einem Substrat, und einen Temperschritt des Erwärmens des Vorläuferlaminats in einer reduzierenden Atmosphäre zum Tempern unter Bildung einer Metalloxidschicht aus der ersten Vorläuferschicht und der zweiten Vorläuferschicht umfaßt, wobei:

   die erste Vorläuferschicht eine Titanoxidschicht ist, hergestellt aus Titanoxid, enthaltend mindestens ein Dotiermittel, ausgewählt aus der Gruppe, bestehend aus Nb, Ta, Mo, As, Sb, Al, Hf, Si, Ge, Zr, W, Co, Fe, Cr, Sn, Ni, V, Mn, Tc, Re, P und B, und die Titanoxidschicht eine Titanoxidschicht ist, welche, wenn einem Einzelschicht-Tempertest unterworfen, eine Titanoxidschicht wird, enthaltend einen Polykristall, welcher frei von einem Kristall vom Rutil-Typ ist, und
   die zweite Vorläuferschicht eine amorphe Titanoxidschicht ist, hergestellt aus Titanoxid, enthaltend mindestens ein Dotiermittel, ausgewählt aus der vorstehenden Gruppe, und die amorphe Titanoxidschicht eine amorphe Titanoxidschicht ist, welche, wenn einem Einzelschicht-Tempertest unterworfen, eine Titanoxidschicht wird, enthaltend einen Polykristall, welcher einen Kristall vom Rutil-Typ enthält,
   wobei der Einzelschicht-Tempertest bezüglicher ersten Vorläuferschicht und der zweiten Vorläuferschicht gemäß dem Verfahren, wie in der Beschreibung angeführt, durchgeführt wird.

2. Verfahren zur Herstellung eines elektrischen Leiters gemäß Anspruch 1, wobei die erste Vorläuferschicht einen Absorptionskoeffizienten von größer als 0 cm$^{-1}$ und weniger als $2\times10^4$cm$^{-1}$ bei einer Wellenlänge von 800 nm aufweist, und
   die zweite Vorläuferschicht einen Absorptionskoeffizienten von mindestens $2\times10^4$cm$^{-1}$ und weniger als $5\times10^4$cm$^{-1}$ bei einer Wellenlänge von 800 nm aufweist.

3. Verfahren zur Herstellung eines elektrischen Leiters gemäß Anspruch 1 oder 2, wobei der Gehalt an Dotiermittelatomen in jeweils der ersten Vorläuferschicht und der zweiten Vorläuferschicht mindestens 1 Atom-% und höchstens 10 Atom-%, bezogen auf die Gesamtmenge an Dotiermittelatomen und Titanatomen, ist.

4. Verfahren zur Herstellung eines elektrischen Leiters gemäß einem der Ansprüche 1 bis 3, wobei die erste Vorläuferschicht eine Dicke von mindestens 5 nm und höchstens 50 nm aufweist, die zweite Vorläuferschicht eine Dicke von mindestens 15 nm aufweist und die Metalloxidschicht eine Dicke von 20 bis 1000 nm aufweist.

5. Verfahren zu Herstellung eines elektrischen Leiters gemäß einem der Ansprüche 1 bis 4, wobei der Laminatbildungsschritt Schritte des Bildens der ersten Vorläuferschicht bzw. der zweiten Vorläuferschicht durch ein Sputterverfahren aufweist und die Konzentration an oxidierendem Sputtergas in einem Atmosphärengas zum Bilden der zweiten Vorläuferschicht geringer als die Konzentration des oxidierenden Sputtergases in einem Atmosphärengas zum Bilden der ersten Vorläuferschicht ist.

6. Verfahren zur Herstellung eines elektrischen Leiters gemäß einem der Ansprüche 1 bis 5, wobei der Laminatbildungsschritt Schritte des Bildens der ersten Vorläuferschicht bzw. der zweiten Vorläuferschicht durch ein Sputterverfahren aufweist und der Gehalt an Sauerstoffatomen in einem Target, verwendet zur Bildung der zweiten Vorläuferschicht, geringer als der Gehalt an Sauerstoffatomen in einem Target, verwendet zur Bildung der ersten Vorläuferschicht, ist.

7. Verfahren zur Herstellung eines elektrischen Leiters gemäß einem der Ansprüche 1 bis 6, wobei in dem Temperschritt das Vorläuferlaminat in einer Wasserstoffatmosphäre oder in einer Vakuumatmosphäre erwärmt wird.

8. Verfahren zur Herstellung eines elektrischen Leiters gemäß einem der Ansprüche 1 bis 7, wobei in dem Temperschritt das Vorläuferlaminat bei einer Temperatur von 250 bis 850°C für mindestens eine Minute gehalten wird.

9. Verfahren zur Herstellung eines elektrischen Leiters gemäß einem der Ansprüche 1 bis 8, wobei in dem Temperschritt das Vorläuferlaminat von der Seite der ersten Vorläuferschicht erwärmt wird.

**Revendications**

1. Procédé de fabrication d'un conducteur électrique, qui comprend une étape de formation d'un stratifié consistant à former un stratifié de précurseur possédant une première couche de précurseur et une seconde couche de précurseur stratifiées dans un ordre facultatif sur un substrat, et une étape de recuit consistant à chauffer le stratifié de précurseur dans une atmosphère réductrice en vue d'un recuit afin de former une couche d'oxyde métallique à partir de la première couche de précurseur et de la seconde couche de précurseur, dans lequel :

   la première couche de précurseur est une couche d'oxyde de titane constituée d'oxyde de titane contenant au moins un dopant choisi parmi le groupe constitué de Nb, Ta, Mo, As, Sb, Al, Hf, Si, Ge, Zr, W, Co, Fe, Cr, Sn, Ni, V, Mn, Tc, Re, P et Bi, et la couche d'oxyde de titane est une couche d'oxyde de titane qui, lorsqu'elle est soumise à un essai de recuit monocouche, devient une couche d'oxyde de titane contenant un polycristal qui est exempt de cristal de type rutile, et
   la seconde couche de précurseur est une couche d'oxyde de titane amorphe constituée d'oxyde de titane contenant au moins un dopant choisi parmi le groupe ci-dessus, et la couche d'oxyde de titane amorphe est une couche d'oxyde de titane amorphe qui, lorsqu'elle est soumise à un essai de recuit monocouche, devient une couche d'oxyde de titane contenant un polycristal qui contient un cristal de type rutile,
   dans lequel l'essai de recuit monocouche sur la première couche de précurseur et la seconde couche de précurseur est mis en oeuvre par le processus tel qu'indiqué dans la description.

2. Procédé de fabrication d'un conducteur électrique selon la revendication 1, dans lequel
   la première couche de précurseur présente un coefficient d' absorption supérieur à 0 cm$^{-1}$ et inférieur à $2 \times 10^4$ cm$^{-1}$ à une longueur d'onde de 800 nm, et
   la seconde couche de précurseur présente un coefficient d'absorption d'au moins $2 \times 10^4$ cm$^{-1}$ et inférieur à $5 \times 10^4$ cm$^{-1}$ à une longueur d'onde de 800 nm.

3. Procédé de fabrication d'un conducteur électrique selon la revendication 1 ou 2, dans lequel la teneur en atomes de dopant dans chaque couche parmi la première couche de précurseur et la seconde couche de précurseur est d' au moins 1 % en atomes et d' au plus 10 % en atomes sur la base de la quantité totale d'atomes de dopant et d'atomes de titane.

4. Procédé de fabrication d'un conducteur électrique selon l'une quelconque des revendications 1 à 3, dans lequel la première couche de précurseur présente une épaisseur d'au moins 5 nm et d'au plus 50 nm, la seconde couche de précurseur présente une épaisseur d'au moins 15 nm, et la couche d'oxyde métallique présente une épaisseur de 20 à 1 000 nm.

5. Procédé de fabrication d'un conducteur électrique selon l'une quelconque des revendications 1 à 4, dans lequel l'étape de formation d'un stratifié comporte les étapes consistant à former la première couche de précurseur et la seconde couche de précurseur, respectivement, par un procédé de pulvérisation, et la concentration d'un gaz de pulvérisation oxydant dans un gaz d'atmosphère pour former la seconde couche de précurseur est inférieure à la concentration du gaz de pulvérisation oxydant dans un gaz d'atmosphère pour former la première couche de précurseur.

6. Procédé de fabrication d'un conducteur électrique selon l'une quelconque des revendications 1 à 5, dans lequel l'étape de formation d'un stratifié comporte les étapes consistant à former la première couche de précurseur et la seconde couche de précurseur, respectivement, par un procédé de pulvérisation, et la teneur en atomes d'oxygène dans une cible utilisée pour former la seconde couche de précurseur est inférieure à la teneur en atomes d'oxygène dans une cible utilisée pour former la première couche de précurseur.

7. Procédé de fabrication d'un conducteur électrique selon l'une quelconque des revendications 1 à 6, dans lequel pendant l'étape de recuit, le stratifié de précurseur est chauffé dans une atmosphère d'hydrogène ou dans une atmosphère sous vide.

8. Procédé de fabrication d'un conducteur électrique selon l'une quelconque des revendications 1 à 7, dans lequel pendant l'étape de recuit, le stratifié de précurseur est maintenu à une température de 250 à 850 °C pendant au moins une minute.

9. Procédé de fabrication d'un conducteur électrique selon l'une quelconque des revendications 1 à 8, dans lequel pendant l'étape de recuit, le stratifié de précurseur est chauffé à partir du côté de la première couche de précurseur.

Fig. 1

Fig. 2

(a)

(b)

## Fig. 3

Fig. 4

## Fig. 5

Fig. 6

Fig. 7

(Ex.1)(Ex.1)(Ex.2)(Ex.3)
-0%   -1%

Fig. 8

Fig. 9

Fig. 10

Fig. 11

Fig. 12

# Fig. 13

Thickness of the first precursor layer (nm)

## Fig. 14

## Fig. 15

## REFERENCES CITED IN THE DESCRIPTION

**Patent documents cited in the description**

- WO 2006016608 A

- JP 2004095240 A

**Non-patent literature cited in the description**

- *Applied Physics,* 2004, vol. 73 (5), 587-592

- *Japanese Journal of Applied Physics,* 2007, vol. 46 (3), L86-L88